(19) Europäisches Patentamt
European Patent Office
Office européen des brevets

(11) **EP 1 071 143 A1**

(12) **EUROPEAN PATENT APPLICATION**
published in accordance with Art. 158(3) EPC

(43) Date of publication:
**24.01.2001 Bulletin 2001/04**

(51) Int. Cl.⁷: **H01L 33/00**, H01S 3/18

(21) Application number: **98957169.0**

(86) International application number:
**PCT/JP98/05479**

(22) Date of filing: **04.12.1998**

(87) International publication number:
**WO 99/30373 (17.06.1999 Gazette 1999/24)**

(84) Designated Contracting States:
**DE FR GB**

(30) Priority: **08.12.1997 JP 33703997**
**10.12.1997 JP 33978097**

(71) Applicant:
**Mitsubishi Cable Industries, Ltd.**
**Amagasaki-shi Hyogo 660-0856 (JP)**

(72) Inventors:
 • **HIRAMATSU, Kazumasa**
   **Mie 510-0822 (JP)**
 • **OKAGAWA, Hiroaki**
   **Itami-shi, Hyogo 664-0027 (JP)**
 • **OUCHI, Yoichiro**
   **Itami-shi, Hyogo 664-0027 (JP)**
 • **MIYASHITA, Keiji**
   **Itami-shi, Hyogo 664-0027 (JP)**
 • **TADATOMO, Kazuyuki**
   **Itami-shi, Hyogo 664-0027 (JP)**

(74) Representative:
**Weber, Thomas, Dr. et al**
**Patentanwälte**
**von Kreisler-Selting-Werner,**
**Deichmannhaus am Dom**
**50667 Köln (DE)**

(54) **GaN-BASED SEMICONDUCTOR LIGHT EMITTING DEVICE AND METHOD OF PRODUCING GaN-BASED CRYSTAL**

(57) The GaN group light emitting element of the present invention comprises a light emitting layer made from a GaN group material having a composition capable of ultraviolet emission, and the light emitting layer has a part having lowered dislocation. The dislocation of the light emitting layer is lowered by the mask method. In a preferable mode, any GaN group crystal layer formed in the light emitting element is $Al_yGa_{(1-y)}N$ ($0<y\leqq1$) and the Al composition $y$ thereof satisfies [energy Eg1 of light emitted from the light emitting layer] < [band gap energy Eg2 of layer(s) other than the light emitting layer]. In addition to the lowering of the dislocation of the light emitting layer by the mask method, preferable collateral embodiments for highly efficient ultraviolet light emission are provided, such as lowering the dislocation of an electrode forming face and a Bragg reflection layer for protection and the like. The production method of the present invention is characterized in that, of the feed gases fed for the crystal growth, an alkyl chloride compound of a group III element is used as a group III feed gas when forming a layer covering a mask layer by MOCVD according to the mask method. This method is preferably applied to the formation of a layer covering a mask in the GaN group light emitting element of the present invention.

FIG. 1

## Description

## Technical Field

The present invention relates to a GaN group semiconductor light emitting element that emits ultraviolet rays (hereinafter to be also referred to as a GaN group light emitting element), and a production method of GaN group crystals preferably used for the element.

## Background Art

A GaN group light emitting element is made from a GaN group material and has been actively studied since the realization of a high luminance light emitting diode (LED) in recent years. Some reports have documented continuous oscillation of a semiconductor laser at room temperature.

The GaN group material and GaN group crystal as referred to in the present specification mean a compound semiconductor material expressed by $In_aGa_bAl_cN$ ($0 \leqq a \leqq 1$, $0 \leqq b \leqq 1$, $0 \leqq c \leqq 1$, $a+b+c=1$ ) and crystals thereof.

Of the GaN group light emitting elements, an element comprising an InGaN active layer affords emission of green to blue light and a high luminous efficiency. The Second International Conference on Nitride Semiconductors ICNS '97 p516 reports on an LED comprising InGaN as an active layer having a short-wave.

Due to the thermodynamic instability of InGaN, a light emitting layer of InGaN as a whole cannot have a uniform composition ratio, but has locally different In composition ratios. The different ratios form dots of a several nm order that are dispersed in the light emitting layer. The dots are said to produce recombination radiation of carrier, which is considered one of the factors that achieve emission of light from the InGaN light emitting layer at a high luminous efficiency.

For ultraviolet rays to be emitted from an InGaN light emitting layer, the band gap of the material of the light emitting layer should be increased. For this to be achieved, an In composition ratio of InGaN is made smaller, thereby making the composition closer to GaN, or In composition ratio is made smaller while adding Al to make the composition InGaAlN or AlGaN. However, a smaller In composition ratio results in a failure to form the above-mentioned dots, which in turn results in lower luminous efficiency.

For example, when the In composition is reduced toward GaN, the luminous efficiency radically falls from around the region where the light emitting wavelength changes to the ultraviolet ray region, along with a decreased light emission output. In the above-mentioned report, an output of 5 mW (current 20 mA) at the light emitting wavelength of 371 nm decreases to 1/10 only by decreasing the In composition ratio and making the light emitting wavelength 368 nm.

The same applies to the case where Al composition is added to the material of a light emitting layer toward InAlGaN. When the In composition ratio is reduced, the luminous efficiency becomes low. In particular, an AlGaN light emitting layer having an In composition ratio of 0 is impractical.

It is therefore an object of the present invention to provide a GaN group light emitting element comprising, as a light emitting layer, InAlGaN having a composition ratio affording the emission of ultraviolet rays, which enables emission of ultraviolet rays at a higher luminous efficiency.

Another object of the present invention is to provide various modes of the GaN group light emitting element preferably used to achieve the above-mentioned object, which can inhibit occurrence of cracks and absorption of light by a part other than the light emitting layer.

A yet another object of the present invention is to provide a production method of GaN group crystal useful for the GaN group light emitting element of the present invention.

## Disclosure of the Invention

The present inventors have conducted intensive studies in an attempt to emit ultraviolet rays at a high luminous efficiency from an InGaAlN (having a composition ratio affording emission of ultraviolet rays) light emitting layer, and found that, by lowering the dislocation of a light emitting layer, particularly the part involved in light emission, the emission of ultraviolet rays at a sufficiently high efficiency can be achieved, even without dots due to In, which resulted in the completion of the present invention.

The light emitting element of the present invention comprises a light emitting layer made of $In_aGa_bAl_cN$ ($0 \leqq a \leqq 1$, $0 \leqq b \leqq 1$, $0 \leqq c \leqq 1$, $a+b+c=1$ ) that emits ultraviolet rays. The GaN group semiconductor light emitting element is characterized by the light emitting layer comprising a part having lowered dislocation.

In a preferable mode, all the layers made of GaN group crystal, that are formed in the light emitting element, consist of $Al_yGa_{(1-y)}N$ ($0 < y \leqq 1$), wherein the Al composition у satisfies [energy Eg1 of light emitted from the light emitting layer]<[band gap energy Eg2 of layer(s) other than the light emitting layer], except the material of the light emitting layer when it is an active layer.

In a preferable mode, the dislocation of the light emitting layer is lowered by a mask layer and a layer covering the mask layer, that have been formed between a base substrate and a light emitting layer. At least one pair of a mask layer and a layer covering the mask layer is formed in the laminating direction, wherein the mask layer is partially formed on the surface where the mask layer is formed, such that a masked region and a non-masked region can be formed. The material of the mask layer is substantially free from GaN group crystal growth from its surface, and the layer covering the mask layer is a GaN group crystal layer grown on the aforementioned non-masked region as the growth starting plane until it covers the upper surface of the mask layer.

The method for producing the GaN group crystal of the present invention comprises the steps of forming a mask layer on a crystal face, where a GaN group crystal can grow, to provide a masked region and a non-masked region, the material of the aforementioned mask layer being substantially free from GaN group crystal growth from its surface, and growing a GaN group crystal by vapor phase growth on the aforementioned non-masked region as the growth starting plane until it covers the upper surface of the mask layer to give a layer covering the mask layer, and is characterized in that, of the feed gases supplied for crystal growth, the group III feed gas is an alkyl chloride compound of a group III element. This method is preferably applied to the formation of a layer covering the mask layer included in the GaN group semiconductor light emitting element of the present invention.

Prior to the detailed description of the present invention, expressions and terms are explained.

In this specification, when the lattice plane of a hexagonal lattice crystal, such as GaN group crystal and sapphire substrate, is identified by four Miller indices (hkil), the general expressions of Miller indices will be followed except that, when the index is minus, a minus symbol is put before the index for easy expression. In the case of a GaN group crystal, the number of the prism planes (singular surface) parallel to the C axis is 6. One of them is expressed by, for example, (1-100), and when six planes are collectively referred to, {1-100} is used. In addition, the planes perpendicular to the aforementioned {1-100} plane and parallel to the C axis are equivalently and collectively referred to as {11-20}. Furthermore, the direction perpendicular to the (1-100) plane is expressed by [1-100], and the directions equivalent thereto are collectively expressed by 〈1-100〉 the direction perpendicular to the (11-20) plane is expressed by [11-20], and the directions equivalent thereto are collectively expressed by 〈11-20〉 When the Miller indices are to be incorporated in a Figure, the general expressions of Miller indices will be followed except that, when the index is minus, a minus symbol is put on the index. Any crystal direction used in the present invention is based on the GaN group crystal grown on the base substrate.

For convenience's sake, the laminate structure of a GaN group light emitting element is explained on the assumption that a base substrate is positioned on the lower layer side, on which GaN group crystal layers are layered upward. The upper-lower directions are assumed for the laminate structure of the element, and the terms, "upper layer", "upper surface", "upper" and the like are used.

Of the both electrodes formed on a light emitting element, an electrode formed on the upper layer side from the light emitting layer is referred to as an upper electrode and the other electrode is referred to as a lower electrode.

The "masked region" and the "non-masked region" are both areas within the plane where a mask layer is formed. The upper area of the mask layer is regarded as equivalent to the masked region and used for explanation as such.

While the upper-lower positional relationship between p-type and n-type of a GaN group light emitting element is not limited, the base substrate side (lower layer side) is generally used for n-type for the reasons relating to processing, and so is taken in the explanation to follow. In this connection, the positions of electrodes are explained in the embodiments using an insulator (e.g., sapphire crystal substrate) as a base substrate. In this embodiment, a part of the upper surface of the laminate is removed to expose an n-type contact layer on the lower layer side, an n-type electrode is formed on the exposed surface, and a p-type electrode is formed on the p-type contact layer on the upper layer side of the remaining laminate. However, this embodiment is not limitative, and the order of p-type and n-type may be reversed, a conductive base substrate may be used to form a lower electrode on the base substrate, or a different optional embodiment may be employed.

**Brief Description of the Drawings**

In the Figures, the ratios of thickness and width of each layer - are magnified for explanation and are different from the actual ratios. - In addition, the electrode, light emitting layer and mask layer are hatched to distinguish them from other layers.

Fig. 1 shows one embodiment of the GaN group light emitting element of the present invention.

Fig. 2 shows a growth method of a GaN group crystal using a mask layer.

Fig. 3 schematically shows the growth state of a GaN group crystal and advance direction of dislocation line when the ratio of the growth rate in the C axis direction is greater when growing a GaN group crystal layer covering the mask layer.

Fig. 4 schematically shows the growth state of a GaN group crystal and advance direction of dislocation line when the ratio of the growth rate in the direction perpendicular to the C axis is greater when growing a GaN group crystal layer covering the mask layer.

Fig. 5 shows another embodiment of the GaN group light emitting element of the present invention.

Fig. 6 shows still another embodiment of the GaN group light emitting element of the present invention, wherein a base substrate comprising a GaN group crystal layer having lowered dislocation on its surface.

Fig. 7 shows a preferable embodiment of the mask layer.

Fig. 8 shows a preferable embodiment of the mask layer.

Fig. 9 shows another embodiment of the GaN group light emitting element of the present invention.

Fig. 10 shows a preferable growth method of the GaN group crystal using a mask layer.

Fig. 11 shows an embodiment for lowering the dislocation of the plane where the upper electrode is formed.

Fig. 12 shows another embodiment for lowering the dislocation of the plane where the upper electrode is formed.

Fig. 13 - Fig. 18 show preferable modes when a Bragg reflection layer is formed in an element.

Fig. 19 is a graph showing the composition ratio of $In_aGa_bAl_cN$ affording emission of ultraviolet rays, based on a graph showing the relationship between lattice constant and band gap energy when the composition ratio of $In_aGa_bAl_cN$ was varied.

## Detailed Description of the Invention

The light emitting element of the present invention is explained in detail by referring to an LED having a simple structure.

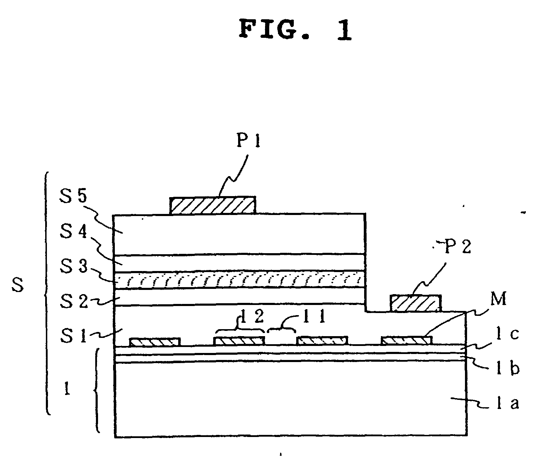

Fig. 1 shows a GaN group LED comprising an $In_aGa_bAl_cN$ as the material of a light emitting layer S3, which has a composition ratio ($0 \leqq a \leqq 1$, $0 \leqq b \leqq 1$, $0 \leqq c \leqq 1$, $a+b+c=1$ ) affording emission of ultraviolet rays. This light emitting layer S3 is made to have a lower dislocation, thereby to emit ultraviolet rays at a high efficiency which is conventionally unattainable. The element has a structure wherein a base substrate 1 is the lowermost layer, the layers of GaN group crystals (n-type GaN contact layer S1, n-type AlGaN cladding layer S2, GaN light emitting layer S3, p-type AlGaN cladding layer S4, p-type GaN contact layer S5) are sequentially laminated on this base substrate by crystal growth to form laminate S, and electrodes P1, P2 are formed thereon. The light emitting layer S3 is an active layer sandwiched between two cladding layers S2 and S4 in a double heterojunction structure. The base substrate 1 comprises a base sapphire crystal substrate 1a, and a buffer layer 1b and a GaN group crystal thin film layer 1c to improve lattice match, sequentially formed on the substrate.

Fig. 1 shows an embodiment wherein dislocation generated in the interface between a base substrate and a GaN group crystal grown thereon, due to lattice mismatch between the two, is inhibited, and the necessary part of a light emitting layer is made to have lowered dislocation. The generated dislocation is inhibited by forming a mask layer M and a layer S1 covering the mask layer, between the base substrate 1 and a light emitting layer S3. The mask layer M is partially formed on the upper surface of the layer (base substrate 1 in Fig. 1) on which the mask layer is formed, thereby to form a masked region 12 and a non-masked region 11. The layer S1 covering the mask layer is a GaN group crystal layer obtained by crystal growth on a non-masked region 11 as a growth start plane, until it covers the upper surface of the mask layer M. A method for growing a GaN group crystal using this mask layer, and lowering of the dislocation achieved thereby, are explained in the following.

A general production method of a GaN group light emitting element comprises the steps of growing a buffer layer at a low temperature on a sapphire crystal substrate, and forming a light emitting part made of a GaN group crystal. However, the crystal is subject to occurrence of dislocation due to the factors such as lattice mismatch between the substrate and GaN group crystal, contamination with impurities, distortion in multilayer film interfaces and the like. The generated dislocation is succeeded by the upper layer with the growth of a crystal layer, even if the layer has a growing thickness, thereby forming a continuous defective part called a dislocation line (through dislocation).

In particular, a sapphire crystal substrate is known to have a dislocation density of not less than $10^{10}$ $cm^{-2}$ due to the big lattice mismatch between the substrate and the GaN group layer. Such highly dense dislocation is succeeded by the upper layer as a dislocation line when a laminate structure of a GaN group light emitting element is formed.

In the present invention, the necessary part of the light emitting layer is freely made to have lowered dislocation by controlling the advance direction of the dislocation line that is generated on the lower layer side and reaches the light emitting layer, or by stopping the controlled dislocation line with a mask layer, or by reducing the occurrence of dislocation line by the use of a GaN group crystal substrate having lowered dislocation as a base substrate. For example, only a current constriction structure, that attributes to a locally intense light emission of the light emitting layer, can be made to have lowered dislocation.

Lowering of the dislocation enables a light emitting layer made of $In_aGa_bAl_cN$ (including GaN, AlGaN) having a composition ratio affording emission of ultraviolet rays to have a sufficiently high luminous efficiency. It is postulated that the dislocation less frequently functions as a non-radiative recombination center and less frequently functions as a passage of current to cause current leakage. As a result, a carrier can preferably bond even in the absence of dots due to In.

To lower the dislocation of a light emitting layer or to form a base substrate having low dislocation, the present inventors have found the following.

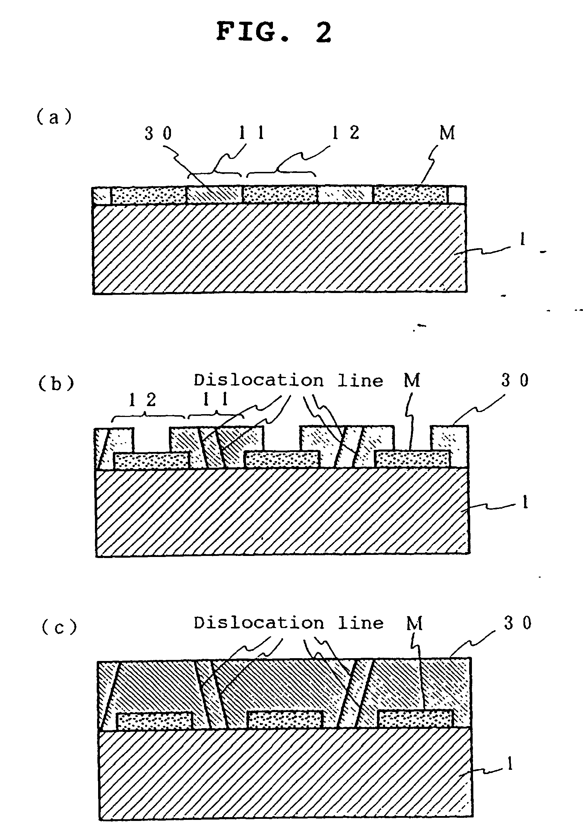

The present inventors previously proposed to prevent cracks of a GaN group crystal layer due to different lattice constants between a GaN group crystal and a sapphire crystal substrate, by, as shown in Fig. 2(a), forming a mask layer M (having lattice pattern) on a base substrate 1, and growing a GaN group crystal layer 30 only on a non-masked region 11 where the substrate surface is exposed, thereby to spread the chip sized GaN group crystal layers 30 in the entirety of the substrate surface (JP-A-7-273367).

Later studies of the present inventors have revealed that, when the spread GaN group crystal layers 30 are further grown, the growth occurs not only in the thickness direction (C axis direction) but also in the transverse direction (direction perpendicular to C axis) of from each GaN group crystal layer 30 onto the mask layer M, as shown in Fig. 2(b). In addition, the rate of growth in the transverse direction often becomes as high as the growth in the thickness direction, depending on the crystal orientation. This has confirmed dependency on crystal orientation.

When upward growth beyond the mask layer is performed, the growth in the thickness direction and the transverse direction can be continued. As shown in Fig. 2(c), the GaN group crystal completely covers the masked region to embed the mask layer. Consequently, a flat, large and thick GaN group crystal layer 30 associated with extremely less defects such as dislocation and without cracks can be obtained.

The GaN group crystal layer 30 shows lower dislocation as a whole, when compared to a layer without a mask layer. As shown in Fig. 2(b), 2(c), however, a dislocation line invades in the GaN group crystal layer 30 through a non-masked region.

It was further found by the subsequent studies of the present inventors that, when a crystal growth is performed to the point that the mask layer is formed and the mask layer is embedded as mentioned above, the upward advance direction of the dislocation line in the layer could be controlled by appropriately combining the pattern of mask layer, crystal growth method and atmospheric gas during crystal growth. This control method has enabled desired changes in the advance direction of the dislocation line from the non-masked region to the upward of the adjacent masked region, or from the non-masked region to straight upward or a direction upward to any region.

Hereinafter, a method for obtaining a GaN group crystal having lowered dislocation using a mask layer is also referred to as a "mask method" and the GaN group crystal layer to be grown until it embeds a mask layer is referred to as a "layer covering the mask layer" or simply as a "covering layer" during explanation.

Positive control of the upward advance direction of the dislocation line using a mask layer and a layer covering the mask layer - can lower the dislocation of an important portion on an upper layer side beyond the mask layer, such as a part where ultraviolet rays are generated or an upper electrode forming face, which in turn results in improved output and service life of an element.

The base substrate may be any as long as a GaN group crystal can grow. Particularly preferred is one capable of growth with the C axis as the thickness direction. For example, sapphire, crystal, SiC and the like widely used for GaN group crystal growth can be used. Of these, C plane and A plane of sapphire, 6H-SiC substrate, particularly C plane sapphire substrate, are preferable. In addition, a buffer layer of ZnO, MgO, AlN, GaN and the like may be formed on the surface of the material to reduce difference in the lattice constant from the GaN group crystal, or a thin film of a GaN group crystal may be formed as the surface layer.

The mask layer is made from a material substantially free of GaN group crystal growth from its surface. Examples of such material include amorphous such as nitride and oxide of Si, Ti, Ta, Zr and the like, namely, $SiO_2$, $SiN_X$, $SiO_{1-X}N_X$, $TiO_2$, $ZrO_2$ and the like. In particular, $SiN_X$ and $SiO_{1-X}N_X$ films superior in heat resistance, film forming property and easy removal by etching can be preferably used.

The mask layer is formed to cover the entire surface of the substrate by vacuum evaporation, sputtering, CVD and the like, a photosensitive resist is patterned by general photolithography, and a part of the substrate is exposed by etching. While the thickness is not limited, it is typically about 50 nm - 500 nm.

By forming a mask layer, of the dislocation lines that have come from the lower layer side than the mask layer, at least those that have reached the masked region can be stopped by the mask layer. Of the dislocation lines that have come from the lower layer side, those that have reached the non-masked region pass through the region and advance onto the upper layer side. In the present invention, the direction of the dislocation line advancing to the upper layer side is positively controlled by the layer covering the mask layer. This is explained in the following.

The GaN group crystal layer, which covers the mask layer, starts crystal growth from the non-masked region. When the GaN group crystal is grown, the ratio of the growth rate of the GaN group crystal in the C axis direction and the growth rate in the direction perpendicular to the C axis is controlled to make the shape of the crystal surface when the crystal grows higher than the mask layer roughly the following (1) and (2).

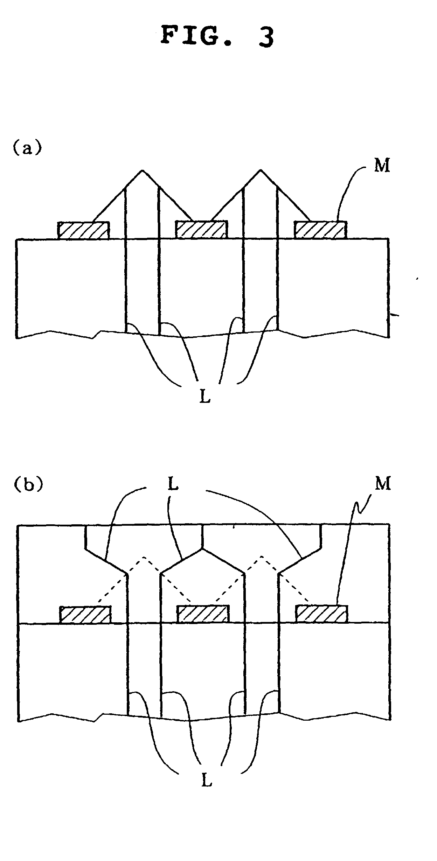

(1) When the ratio of the growth rate in the C axis direction is greater, the crystal surface first has a pyramidal shape as shown in Fig. 3(a) Consequently, the direction of the dislocation line L can be bent from the upper part of the non-masked region toward the upper part of the adjacent masked region. Continued crystal growth makes the crystals from the adjacent masked regions join and form a flat top, as shown in Fig. 3(b). The dislocation line at this time heads upward along the interfluent plane of the crystals, whereby the dislocation of the upper part of the non-masked region can be lowered.

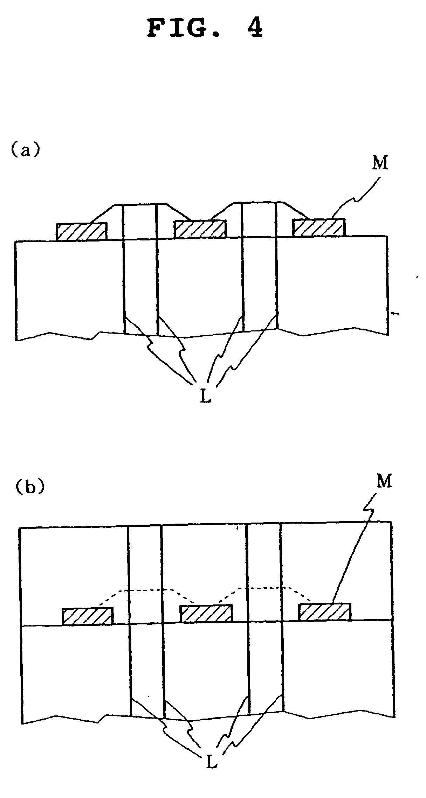

(2) When the ratio of the growth rate in the direction perpendicular to the C axis is greater, the crystal surface upon crystal growth has a trapezoid shape with a flat top from the start, as shown in Fig. 4(a). Consequently, the direction of the dislocation line L can be straight upward, as show in this Figure. Continued crystal growth makes the crystals from the adjacent masked regions join to maintain the flat top, as shown in Fig. 4(b), resulting in a greater thickness of the crystal layer. The dislocation line at this time continuously heads upward, whereby the dislocation of the upper part of the masked region can be lowered.

The factor to control the ratio of the growth rate in the above-mentioned C axis direction (thickness direction) and the growth rate in the direction perpendicular to the C axis (transverse direction) is the combination of pattern of the mask layer, crystal growth method and atmospheric gas during crystal growth. The layer covering the mask layer shows crystal growth in the above-mentioned (1) and (2), and the advance direction of the dislocation line can be determined.

The mask can have an optional pattern. The pattern may have an opening in the shape of a circle, an ellipse, a star, a polygon etc. as a non-masked region, or either or both of the masked region and non-masked region may be linear.

To control the advance direction of the dislocation line, the direction of the visible outline of the masked region, namely, the direction of the boundary line between the masked region and the non-masked region is important.

When the boundary line between the masked region and the non-masked region is a straight line extending in the ⟨11-20⟩ direction of the GaN group crystal, the {1-101} plane, which is a facet plane, is secured as a plane to allow growth in the transverse direction beyond the boundary line, and the growth rate in the transverse direction becomes late. As a result, the pyramidal shape is first formed as in the above-mentioned (1) and then flattened. For this to be achieved, a certain thickness is required to embed the pyramidal crystal flat.

Conversely, when the boundary line between the masked region and the non-masked region is a straight line extending in the ⟨1-100⟩ direction of the GaN group crystal, the {11-20} plane or the {11-22} plane of the GaN group crystal is secured as a plane to allow growth in the transverse direction along the upper surface of the mask layer beyond the boundary line. Since these planes are off-facet planes, the GaN group crystal grows rapidly in the transverse direction as compared to the {1-101} plane, as in the above-mentioned (2), which is a facet plane. Consequently, the thickness necessary for embedding flat can be smaller than in ⟨11-20⟩

One example of the pattern most notably showing an effect of the above-mentioned mask pattern is a stripe mask pattern. The striped mask pattern is formed by arranging strip-like mask layers in a striped pattern. Therefore, a strip masked region and a strip non-masked region are arranged alternately. The longitudinal direction of the stripe (i.e., each strip) is the direction of the boundary line between the above-mentioned masked region and the non-masked region. Thus, the ⟨1-100⟩ direction and ⟨11-20⟩ direction of the GaN group crystal are important longitudinal directions of the stripe. The mask pattern is not limited to stripes but may be any pattern in consideration of the direction of the boundary line.

The method of crystal growth of a layer covering the mask layer is exemplified by HVPE and MOCVD. In particular, when a thick film is prepared, HVPE having a high growth rate is preferable, and in the case of a thin film, MOCVD is preferable.

The atmospheric gas for crystal growth is exemplified by $H_2$, $N_2$, Ar, He and the like. For the control of the growth rate, $H_2$ and $N_2$ are preferably used.

When the crystal is grown in an $H_2$ rich atmospheric gas, the growth rate in the C axis direction becomes fast. In particular, when the direction of the boundary line between the masked region and the non-masked region is a straight line in the ⟨11-20⟩ direction (slow in the transverse direction), a notable pyramidal shape is first formed as in the above-mentioned (1) and then flattened, as in the above-mentioned (1). For this to be achieved, therefore, a certain thickness is required.

When crystal is grown in an $N_2$ rich atmospheric gas, the growth rate in the C axis direction becomes slow, as compared to an $H_2$ rich atmosphere, which results in relatively high growth rate in the transverse direction. When the growth in the transverse direction is made faster as a result of a combination with a mask pattern, the above-mentioned (2) is achieved and the dislocation line can be headed upward.

The crystal growth by MOCVD is mostly performed in an $H_2$ rich atmosphere. In the present invention, it is also possible to carry it out in an $N_2$ rich atmosphere.

One example of the $H_2$ rich atmosphere comprises the use of hydrogen 10 (L) for carrier gas + hydrogen 100 (cc) far organometallic bubbling as a group III gas, and hydrogen 5 (L) for carrier gas + ammonia 5 (L) as a group V gas. In this case, the hydrogen concentration is 75% and the nitrogen concentration is 0%.

When the above-mentioned group III carrier gas is changed to nitrogen, the nitrogen concentration is about 50%. When the group V carrier gas alone is changed to nitrogen, the nitrogen concentration is about 25%. In the present invention, therefore, a nitrogen concentration of about 25% and above is considered N₂ rich for crystal growth by MOCVD.

The following explains a case wherein plural sets of a mask layer and a layer covering the mask layer are formed in the laminating direction. This embodiment enables to lower the dislocation of the upper layer side as a whole.

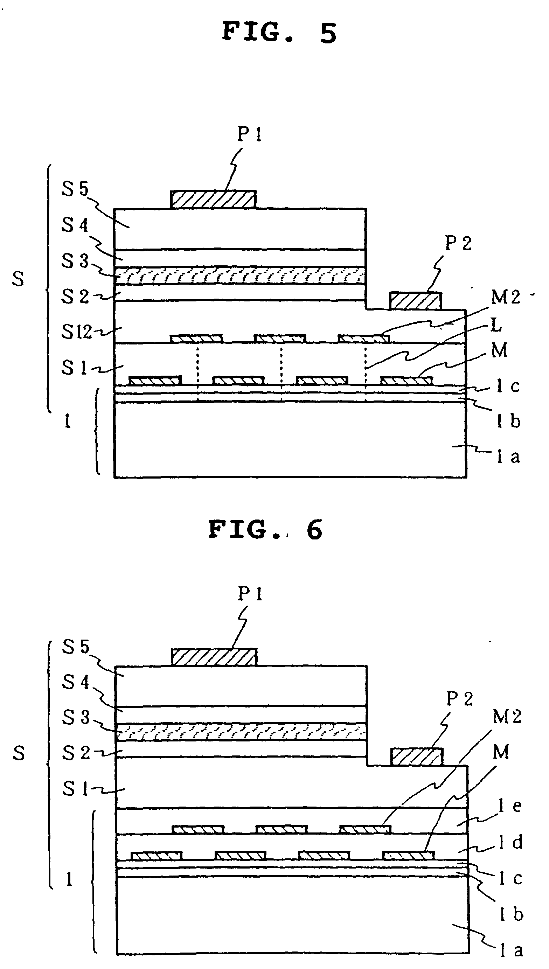

Fig. 5 shows an embodiment comprising two sets of a mask layer and a layer covering the mask layer. In this embodiment, a second mask layer M2 and a second covering layer S12 are formed on the upper surface of the layer S1 of LED of Fig. 1. On the upper surface of the covering layer S1 on the lower layer side exists an area where the dislocation line L has reached. In the present invention, a mask layer M2 on the upper layer side is formed covering this area and the layer S12 that covers this mask layer is grown. In this structure, the second mask layer M2 stops the dislocation line L that advances toward the upper layer through layer S1. Consequently, the layer on the upper layer side beyond the second covering layer S12 comes to have lowered dislocation throughout the layer. The number of the sets of the mask layer and the layer covering the mask layer may be any that is necessary. It is also possible to still lower the dislocation by repeat forming the set many times.

The embodiments of Figs. 1, 5 intend to treat, within the element, the dislocation line generated during preparation of a light emitting element before it reaches the light emitting layer, whereby to lower the dislocation of the light emitting layer. The following explains a mode wherein the dislocation of a light emitting layer is lowered by the use of a base substrate having a GaN group crystal layer having low dislocation at least as a surface layer from the first.

Fig. 6 shows an embodiment of a base substrate having such a structure. In this Figure, a base substrate 1 comprises covering layers 1d, 1e made of a GaN group crystal formed on a substrate (crystal substrate 1a, buffer layer 1b, GaN group crystal thin film layer 1c) having the same structure as the base substrate explained in Figs. 1, 5 as the lowermost layer. The surface layer of the base substrate 1 is made to have lowered dislocation by the same method (Fig. 1, Fig. 5) as used for lowering the dislocation of the light emitting layer by the mask method mentioned above. The covering layer may be one or more layers.

The mode shown in Fig. 6 can be considered an "embodiment wherein the mask layer and the layer covering the mask layer in Fig. 5 are included in the base substrate". When, for example, the base substrate 1 shown in Fig. 6 is formed, if the surface layer 1e made of a GaN group crystal can be grown to have lowered dislocation and a thickness sufficient to make a substrate, the GaN group crystal part alone of the surface layer 1e may be cut off, or an optional thickness of the surface layer 1e including the surface thereof may be cut off and used as a base substrate. The use of such base substrate can afford a light emitting element without having a mask layer inside.

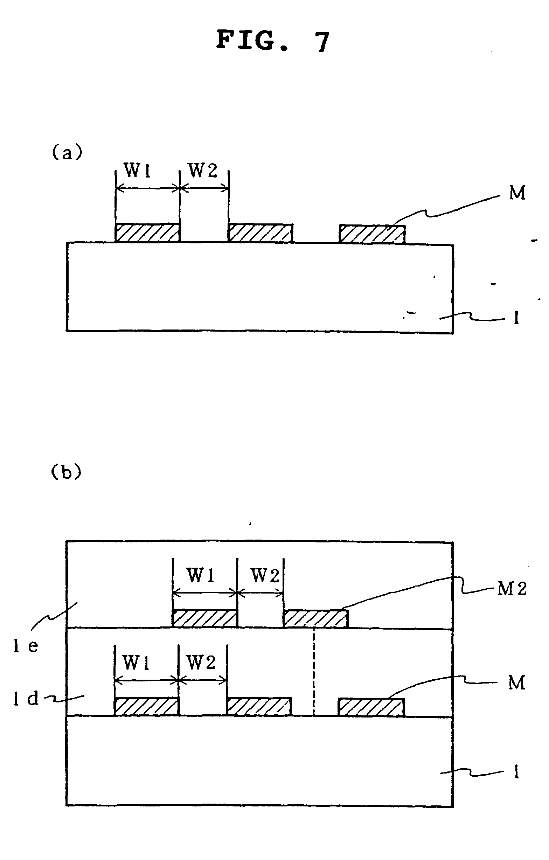

When the set of a mask layer and a layer covering the mask layer is to be formed in multilayers, the upper mask layer is placed to correspond to the lower non-masked region, as explained with regard to Fig. 5. When the upper mask layer is made greater than the lower non-masked region, the dislocation line extending from the lower side can be stopped more completely by the upper mask layer. For example, as shown in Fig. 7(b), the pattern of the mask layers M, M2 is a striped pattern, and multilayers can be formed repeatedly with the same pattern. As shown in Fig. 7(a), the ratio of the width of the mask layer (W1) and width of the non-masked region (W2) preferably satisfies $\{(W1-W2)/(W1+W2)\} \geqq 0.1$. By laminating the striped pattern formed at this ratio, the upper and lower masked regions overlap preferably, as shown in Fig. 7(b), thus contributing to lowering of the dislocation of the upper layer side.

The mask layer is formed from a specific material, such as $SiO_2$ and $SiN_x$, on which a GaN group crystal cannot grow as mentioned above, and is transparent to the light of a wide wavelength range inclusive of visible range. Moreover, a mask layer is formed extremely thin, and, when a GaN group crystal layer has grown, is embedded inside to make its identification difficult.

In the present invention, the mask layer cannot be identified easily. Therefore, this layer cannot be the standard for positional setting during processing after growth of GaN group crystal layer. To solve this problem, the present invention proposes to visualize the mask layer.

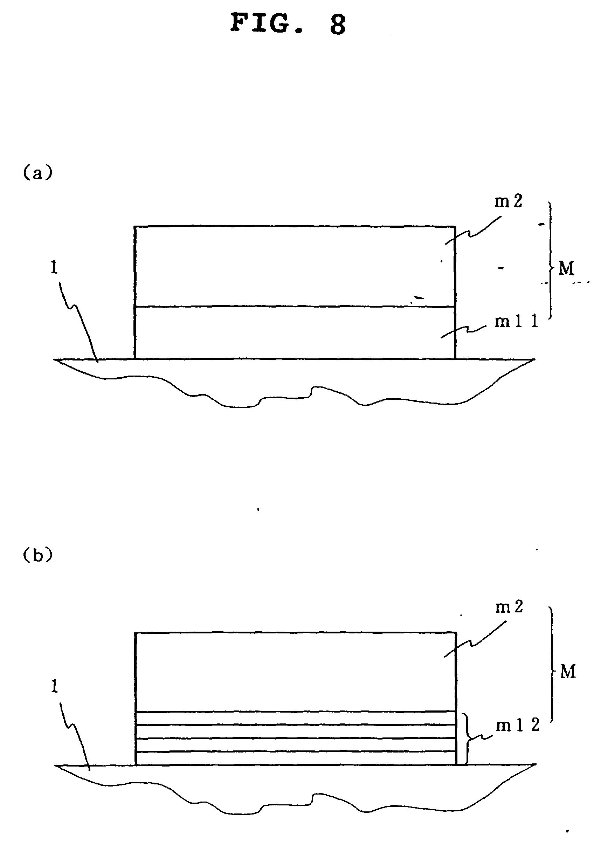

A mask layer can be visualized by the following modes (1) and (2). (1) A distinguishing substance that prevents transmission of a wavelength light selected from ultraviolet rays - infrared rays is dispersed in a mask layer. (2) As shown in Fig. 8, a non-transmission layer having the same pattern as the mask layer, that prevents transmission of a wavelength light selected from ultraviolet rays - infrared rays, is further formed between the surface on which to form a mask layer and the mask layer. These modes (1) and (2) enable visual or optical distinction of the mask layer.

By "prevents transmission of light" in the above-mentioned (1) is meant absorption of light by the size of a band gap. When the substance absorbs light, the light may be emitted after absorption, as in luminescent light. By "prevents transmission of light" in the above-mentioned (2) is meant reflection besides the above-mentioned absorption of light. The reflection means reflection of light due to the property of an opaque material such as a metal, or reflection by a structure designed and constructed to reflect a light having a specific wavelength, such as a Bragg reflection layer. By "prevents transmission of light" is meant not only complete prevention of light transmission but also prevention of light to the degree a non-transmission layer can be visually or optically easily distinguishable.

The wavelength of a light not transmitted is not limited. By making the light in the visible region and the region nearby (about 350 nm - 800 nm) non-transmissible, the distinguishing becomes easy. The non-transmissible wavelength region may be limited to a part or the entirety of the visible region to permit visual distinction by a person.

In the above-mentioned mode (1), the mask layer develops color by the wavelength light not absorbed by the distinguishing substance. When this substance absorbs all the wavelength light in the visible range, the mask layer assumes a dark color. In any case, the mask layer itself is colored, facilitating visual distinction of its presence.

In the above-mentioned mode (2), a mask layer m2 is distinguished by the non-transmission lower layer m11, as shown in Fig. 8(a). Since the mask layer m2 is extremely thin, it may be considered an approximate position of the mask layer.

The mask layer is exposed to a high temperature that may reach 1000°C, at which a GaN group crystal is grown. Therefore, it is essential that the distinguishing substance of (1) does not lose the property to absorb light at this temperature. The same applies to the non-transmission layer of (2). It is important that the layer does not melt or decompose when exposed to such growth conditions, maintain itself as a layer, and does not lose property to prevent light transmission. By "does not lose" here is meant not only invariability The wavelength to be reflected and absorbed and the level of reflection and absorption may change due to the high temperature and the like, only if the property to permit visual or optical distinction is maintained.

The distinguishing substance of the above-mentioned (1) may be Fe, Cr, Nd and the like. When Fe and Cr are dispersed, brown is developed, and when Nd is dispersed, blue is developed. The method for dispersing the distinguishing substance in the mask layer is not limited. The distribution of the distinguishing substance dispersed in the mask layer is not limited, but that affording distinction of the outer line of the mask layer is preferable.

The distinguishing substance is dispersed in the mask layer by, for example, forming, in the mask layer-forming step, a layer covering the entire substrate with a material of the mask layer, bringing a chloride of a distinguishing substance into contact with the mask surface and heat-treating to disperse the atom of the substance. Then, the mask layer is patterned. It is also possible to alternately form a thin layer made from the mask material and a thin layer made from the distinguishing substance by sputtering to give multilayers, which are finally heat treated to allow dispersion of the substance in the entirety thereof.

The non-transmission layer of the above-mentioned (2) is specifically exemplified by a layer m11 made from an opaque material (e.g., metal layer) as shown in Fig. 8(a) and a reflection layer m12 having a multilayer structure designed and constituted to allow reflection (e.g., Bragg reflection layer) as shown in Fig. 8(b). The material of the layer m11 made from an opaque material, as shown in Fig. 8(a), particularly a metallic layer, may be a high melting point material, such as W, Ti and the like. The constitution of the reflection layer m12 as shown in Fig. 8(b), particularly, a Bragg reflection layer, is exemplified by a multilayer film combining GaN group crystal layers, such as a combination of AlGaN/GaN, as a constitution standing the growth conditions of GaN group crystal. Particularly preferred is a laminate of a desired number of pairs of two GaN group crystal layers constituting a superlattice, in view of the high reflection ratio it has. The total thickness of the mask layer and the non-transmission layer is generally preferably about 50 nm - 500 nm.

The material of each GaN group crystal layer constituting a light emitting element may be any that is expressed by $In_aGa_bAl_cN$ ($0{\leqq}a{\leqq}1$, $0{\leqq}b{\leqq}1$, $0{\leqq}c{\leqq}1$, a+b+c=1 ). It is preferable that the layer other than the light emitting layer be made from a material having a greater band gap than the energy of a light emitted by the light emitting layer, so that the layer will not absorb the light. For example, a combination of a GaN active layer and an AlGaN cladding layer in double heterojunction and the like, wherein the Al composition ratio is greater than the light emitting layer is exemplified, but InGaAlN layers containing In composition may be combined as long as the above-mentioned relationship of the band gap is satisfied.

The structure directly involved in the mechanism of light emission in the laminate may be a structure of two layers joined by simple pn junction, a structure of three layers joined by DH (double heterojunction), SQW (Single Quantum Well) having a superlattice structure, MQW (Multiple Quantum Well), a structure having quantum dots and the like.

The light emitting layer in the case of two layer pn junction is a depletion layer formed in the interface of the junction, and an active layer in the case of DH. In the case of SQW, MQW and quantum dot structure, the light emitting part having a band gap forming a well shape is a light emitting layer, like in DH.

The material of the light emitting layer is the above-mentioned $In_aGa_bAl_cN$ having a composition ratio capable of emitting ultraviolet rays. The ultraviolet rays generally has the upper limit of the wavelength of 400 nm - 380 nm and the lower limit defined as about 1 nm. In the present invention, the upper limit of the wavelength of the ultraviolet rays is set to 400 nm.

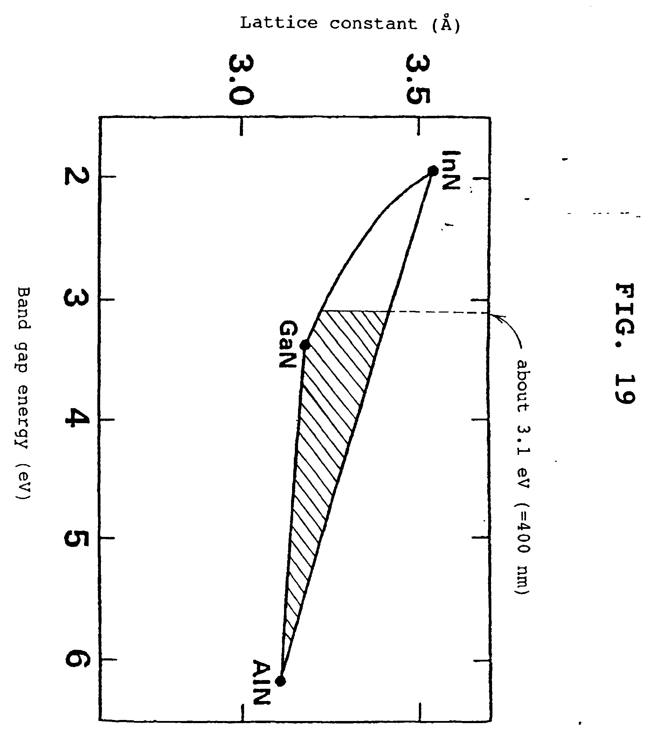

Of the $In_aGa_bAl_cN$, the composition capable of emitting ultraviolet rays is, as shown in the graph of Fig. 19, expressed by the area in the about triangular area enclosed by InN, GaN and AlN, and particularly by the band gap energy of not less than about 3.1 [eV], which corresponds to the wavelength of 400 nm, hatched in the Figure. This hatched area includes the boundary line on the outer periphery. A typical material is $Al_xGa_{(1-x)}N$ $(0 \leqq x < 1)$. Specifically, a preferable material is that wherein x is not more than 0.2. A GaN wherein x=0 is a preferable material because it can increase the difference in the band gap from the cladding layer.

It has been clarified that even a light emitting layer with a smaller In composition can enhance luminous efficiency by lowering the dislocation of the light emitting layer. The dislocation should be lowered to a dislocation density of not more than about $10^7$ cm$^{-2}$. Particularly, by lowering the dislocation density to not more than $10^4$ cm$^{-2}$, a light emitting element having a long service life, a high luminous efficiency and a high output can be obtained.

According to the present invention, the degree of lowering the dislocation of the light emitting layer and other layers is expressed by the dislocation density of the upper surface of the layer. The dislocation density is calculated from the number of dislocations or the number of various singular points generated in response to and caused by the dislocation, in a certain area.

For the observation of the singular points caused by dislocation, the information of the atomic arrangement around the dislocation has become increasingly available by the recent progress of a high resolution electron microscope. However, it has been generally observed using the distortion around the dislocation as a clue. For this type of observation, a typical electron microscope, X-ray diffraction, etch pit, a method utilizing segregation of impurities in the dislocation parts and the like can be used.

More accurately, therefore, the number of dislocations appeared on the target surface may be counted with a transmission electron microscope (TEM). However, the result also approaches an accurate value by amending the number of dislocations observed by the above-mentioned general and simple method.

The measurement area where the number of dislocation is counted is not necessarily the entire upper surface of the layer. In the present invention, only a part of the entire light emitting layer can be made to have lower dislocation and the part can be the center of the light emission. In this case, only the degree of lowering of the dislocation of this part is important. The low density of the part should not be generalized into a value for the entire layer upon combination with the high dislocation of other area. In the present invention, the area having lower dislocation is the upper part of the masked region or non-masked region. Therefore, the area having lowered dislocation can be specified in relation to the position of the mask layer. After specifying the area having lower dislocation, a predetermined sample number n of the measurement areas having a given shape and area are randomly taken out from the area, and the dislocation density of each measurement area is measured and calculated. The n numbers of values of the dislocation density are averaged and taken as the dislocation density.

By lowering the dislocation of the part involved in light emission as mentioned above, ultraviolet rays can be emitted at a sufficiently high efficiency. When InGaAlN is used as the material of the light emitting layer to emit ultraviolet rays, as mentioned above, the luminous efficiency can be improved. However, more preferable element awaits resolution of other problems, which have been newly found by the present inventors. The problem is (3) to satisfy the following (1) and (2).

(1) For crystal growth of a GaN group crystal layer on the first base crystal substrate (e.g., sapphire substrate), a buffer layer is formed on the substrate to reduce lattice mismatch between a substrate and a GaN group crystal, and then a GaN surface layer (several µm) is grown thereon to improve crystallinity, whereby a base substrate is generally obtained. When the surface layer of the base substrate is not a GaN layer (e.g., buffer layer is the surface layer), each layer of a light emitting element to be formed thereon is mainly made of GaN.

(2) To use $In_aGa_bAl_cN$ capable of emission of ultraviolet rays, such as AlGaN, for a light emitting layer, a layer (e.g., cladding layer) involved at least in light emission needs to enclose a carrier, enclose generated light (e.g., semiconductor laser), allow transmission of light, and the like. In view of this, AlGaN having a greater band gap than the light emitting layer needs to be used for such layer.

(3) As in the above-mentioned (1), GaN is conventionally used for each layer constituting the light emitting element. On the other hand, as in the above-mentioned (2), to make the light emitting layer from $In_aGa_bAl_cN$ capable of emitting ultraviolet rays, the layer (e.g., cladding layer) involved in the light emission needs Al composition to give, for example, AlGaN. However, the ultraviolet rays emitted from such a light emitting layer is absorbed by the GaN layer due to the band gap, posing a big problem. In addition, GaN and AlGaN have different lattice constants. Therefore, due to the elevation and drop of temperature, which is repeated until the whole laminate is completed, a large stress is created in the interface of these layers. This sometimes causes occurrence of cracks in either or both of the AlGaN layer and GaN layer. The cracks that occurred in the AlGaN layer can be inhibited by making the AlGaN layer thin, but a GaN layer having a certain thickness is required for the above-mentioned reason (1). Consequently, the problems of light absorption and cracks in the GaN layer cannot be solved.

In contrast, the present inventors have found that the light absorption and cracks in the GaN layer can be inhibited by making the GaN group crystal layer constituting the light emitting element with $Al_yGa_{(1-y)}N$ ($0<y\leqq1$). When the light emitting layer is an active layer, the material of the active layer may not be AlGaN.

In an embodiment constituting each layer with $Al_yGa_{(1-y)}N$, $Al_yGa_{(1-y)}N$ is always used when a GaN group crystal layer is formed as a surface layer of a base substrate on a buffer layer, when other GaN group crystal is formed in the base substrate to lower the dislocation, and as a material for various GaN group crystal layers to constitute a light emitting element. While expressed as always, the composition ratio of y may be changed for every layer, as long as the composition ratio y satisfies [energy Eg1 of light emitted from the light emitting layer] < [band gap energy Eg2 of layer(s) other than the light emitting layer], as mentioned above. This has a consequence that the stress generated by the difference in lattice constant between the GaN layer and the AlGaN layer is alleviated because it turns into the difference between AlGaN layers, thus inhibiting occurrence of cracks.

When the light emitting layer is an active layer, since the active layer is a thin film, the material of the active layer is exceptionally not limited to $Al_yGa_{(1-y)}N$ alone but may be $In_aGa_bAl_cN$ having a composition ratio capable of emission of ultraviolet rays, such as GaN, as long as Eg1<Eg2 is satisfied.

By "the light emitting layer is an active layer" is meant that the layer is formed as a thin film due to the mechanism of the light emission and $Al_yGa_{(1-y)}N$ cladding layers exist directly on or apart from the upper layer side and lower layer side, such as the active layer of a double heterojunction structure. Particularly, when it is an active layer having a thickness of not more than about 50 nm, the use of GaN is tolerable due to less occurrence of cracks and is preferable to enlarge the difference in the band gap from an $Al_yGa_{(1-y)}N$ cladding layer. Examples of the case where a light emitting layer is not an active layer include a simple two layer pn junction structure, in which case $Al_yGa_{(1-y)}N$ is used for both the two layers.

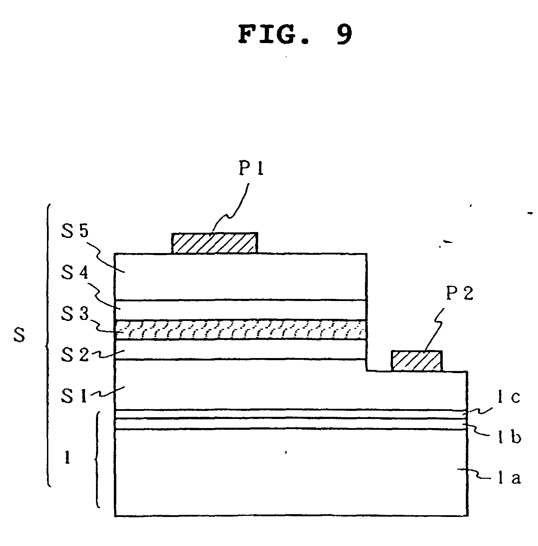

The LED shown in Fig. 9 has a structure wherein a base substrate 1 is the lowermost layer, an n-type $Al_yGa_{(1-y)}N$ contact layer S1, an n-type $Al_yGa_{(1-y)}N$ cladding layer S2, an $Al_yGa_{(1-y)}N$ active layer S3, a p-type $Al_yGa_{(1-y)}N$ cladding layer S4 and a p-type $Al_yGa_{(1-y)}N$ contact layer S5 are formed on the base substrate, and a p-type electrode P1 and an n-type electrode P2 are formed on the laminate S. In the embodiment shown in Fig. 9, the structure for lowering the dislocation of the active layer has been omitted, but it may have a mask layer inside, as in Fig. 1, or without a mask layer. Everything is made of AlGaN, which inhibits occurrence of cracks, and the LED is free of light absorption due to a GaN layer.

As mentioned above, all the GaN group crystal layers of an element are preferably made of AlGaN. The present inventors have confronted a problem in doing so and made an improvement. That is, a problem that, when AlGaN is formed by crystal growth according to the mask method, AlGaN polycrystal grows from the upper surface of the mask layer where the absence of growth of GaN group crystal is assumed, thereby preventing the process of the mask method, and the quality of the crystal is degraded. This is considered to be caused by the fact that Al is extremely active, has a short length of diffusion of the Al reaction species on the mask layer, easily reacts with $SiO_2$ of the mask material, easily reacts with other reaction species and deposits on the mask layer, thereby allowing easy generation of the core of crystal growth on the mask layer. Generally, when AlGaN crystal is to be grown according to the mask method, a GaN surface layer is first grown in a several μm thickness, for improved crystallinity, on a sapphire substrate via a buffer layer to give a base substrate, and an AlGaN group crystal layer is grown on the base substrate. However, this method may improve the crystallinity, but causes occurrence of cracks in either or both of the GaN layer and AlGaN layer, due to the difference in lattice constant between GaN crystal and AlGaN group crystal, and the elevation and drop of temperature repeated until the whole element is completed.

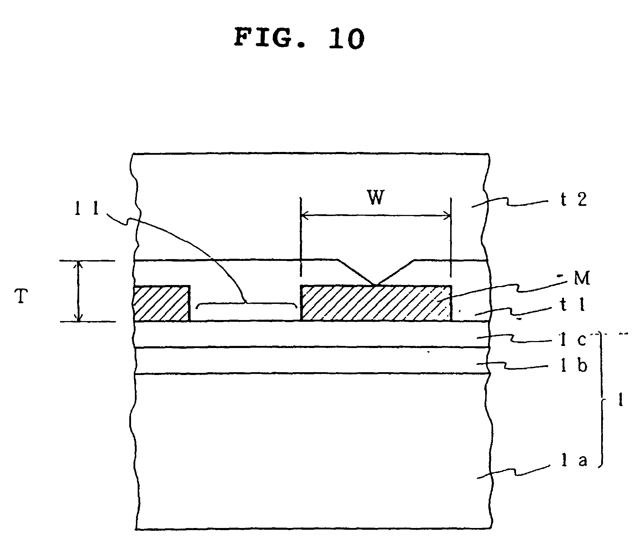

In the present invention, these problems are solved by forming, as a first GaN group crystal layer, a layer covering the mask layer and growing a second GaN group crystal layer thereon. At this time, the first GaN group crystal layer has substantially nil Al composition and the second GaN group crystal layer includes a layer part where the Al composition increases from the boundary of the first GaN group crystal layer with an increasing thickness of the layer. Fig. 10 shows such embodiment, wherein a mask layer M is formed on a base substrate 1, and a first GaN group crystal layer (hereinafter the first layer) t1, and a second GaN group crystal layer (hereinafter the second layer) t2 have been grown. The mask layer M is formed on a substrate surface of the base substrate 1 to provide a masked region and a non-masked region 11. The first layer t1 is a layer covering the mask layer and is obtained by crystal growth on the non-masked region 11 as the crystal growth starting plane. This layer has substantially no Al composition. The second layer t2 is a layer grown on the first layer t1. The second layer t2 has a part where the Al composition increases with an increasing thickness of the layer from the boundary of the first layer t1 up to a predetermined thickness.

This structure inhibits growth of polycrystal on the mask layer, secures a fine process of the mask method and affords a crystal part showing low dislocation. An AlGaN crystal layer having a preferable quality can be obtained, which is free of occurrence of cracks by the action of the part of the second layer t2 where the Al composition increases.

To reduce occurrence of cracks in the embodiment of Fig. 10, the thickness of the GaN crystal covering the mask layer is preferably made as thin as possible. For this end, increase of the Al composition is preferably started when the GaN crystal has covered the mask layer.

As the base substrate, one having a buffer layer on the surface may be also used. The material of the buffer layer may be known, but $Al_xGa_{1-x}N$ (0<x≦1) is preferably used to inhibit occurrence of cracks by minimizing the difference in the lattice constant between the first layer and the second layer, and to inhibit absorption of light when a light emitting element is constituted.

The first layer is preferably as thin as possible to inhibit occurrence of cracks by minimizing the difference in the lattice constant between the first layer (e.g., GaN) and the second layer (e.g., AlGaN). Therefore, the mask method is most optimally applied employing (a) the ⟨1-100⟩ direction of GaN group crystal, (b) MOCVD method, and (c) nitrogen rich gas as atmosphere during crystal growth, as explained above.

The first layer keeps growing in the thickness direction while growing in the transverse direction along the upper surface of the mask layer. As shown in Fig. 10, therefore, a thickness T of the first layer at the moment it covered the upper surface of the mask layer (thickness of the non-masked region from the upper surface of base substrate 1) is determined by the growth rate of the first layer in the transverse direction and the width W of the mask layer. Therefore, by narrowing the width W of the mask layer, the value itself of the thickness T becomes small. The ratio of the thickness T of the first layer to the width W of the mask layer can be made smaller depending on the conditions of the above-mentioned (a)-(c).

The material of the first layer may be any InGaAlN that contains substantially no Al composition. A typical example is GaN optionally containing a suitable In composition. As mentioned later, the second layer is preferably AlGaN. In this case, the lowermost part of the second layer is GaN, due to the gradient of the Al composition. Again, the material of the first layer is preferably GaN to make the difference in the lattice constant smaller.

Inasmuch as the first layer is preferably as thin as possible, when the first layer has covered the mask layer, this layer is preferably made to form a second layer. The thickness of the first layer (thickness T of non-masked region from the upper surface of the base substrate in Fig. 10) is preferably 0.1 μm - not more than 3 μm, which range obviates cracks or absorption of light.

The second layer need only be InGaAlN, but most preferably $Al_xGa_{1-x}N$ (0<x≦1) for inhibition of absorption of light and for smaller difference in lattice constant.

The part having an increasing Al composition in the second layer need only be at least on the boundary plane side of the first layer. For example, (1) the Al composition increases for a given thickness from the boundary plane of the first layer, and, beyond that part on, the Al composition is constant or decreases or varies, or (2) the Al composition increases over the thickness of the second layer.

The Al composition may increase in the second layer in a continuous and non-stepwise manner until it reaches the objective composition ratio, or in a layer-based stepwise manner upon division of the second layer into an optional number of layers. In any case, the level of increase in the Al composition may be linear, arc and the like, which is optionally determined.

The method for crystal growth while increasing the Al composition in the second layer in a continuous and non-stepwise manner is MOCVD, MBE and the like.

The initial Al composition at the part where the Al composition of the second layer increases, namely, the first Al composition at the time point when the second layer starts growing on the first layer is preferably not more than 0.01, particularly substantially 0, to make the difference in the lattice constant from the first layer smaller. Therefore, it is most preferable that a GaN crystal be grown as the first layer, the second layer start growing from the GaN crystal, and the Al composition be increased with an increasing layer thickness until a desired AlGaN composition is achieved.

It is also possible to not form a definite interface between the first layer and the second layer by changing the starting materials to be supplied, in the same crystal growth apparatus. Alternatively, the crystal growth method of the first layer and the second layer may be changed according to the object.

The foregoing is one preferable method to solve the problem of crystal growth on the mask layer due to the presence of Al. In the present invention, a different method to deal with the above-mentioned problem is provided. The method comprises setting the width of the mask layer (for example, the width of mask layer having striped mask pattern) to 0.01 μm - 1 μm. Generally, the width of the mask layer is about 10 μm - 3 μm. By setting the width to a narrow one, such as 0.01 μm - 1 μm, the growth of AlGaN on the mask layer can be inhibited. The width of the non-masked region, when the mask width is 0.01 μm - 1 μm, is preferably about 0.01 μm - 1 μm.

The present invention provides a preferable production method of GaN group crystal as a further method to deal with the problem of crystal growth on the mask layer due to the presence of the above-mentioned Al. The method comprises, in the mask method comprising growing a GaN group crystal having an Al composition as a layer covering the mask layer by vapor phase growth, supplying, of the feed gases supplied for crystal growth, a group III feed gas as an alkyl chloride compound of a group III element.

When GaN group crystal is grown by metallo-organic chemical vapor deposition, a group III feed gas has been conventionally supplied as an alkyl compound of a group III element, such as trimethyl aluminum and trimethyl gallium. In contrast, a Cl composition is added to a group III feed gas and used for a metallo-organic chemical vapor deposition in the present invention, as mentioned above. As a result, Al and Ga that precipitated on the mask layer bind with Cl into AlCl and GaCl. They easily leave the mask layer and the crystal growth on the mask layer can be inhibited. Therefore, even AlGaN can achieve the original growth of the mask method explained earlier to afford a preferable crystal and a light emitting element.

This method is most beneficially used for the metallo-organic chemical vapor deposition (MOCVD) as mentioned above.

The alkyl chloride compound of group III element may be any as long as a Cl composition can be added and the above-mentioned object can be achieved. For example, diethylaluminum chloride and dimethylaluminum chloride are exemplified as the starting material of Al and diethylgallium chloride and dimethylgallium chloride are exemplified as the starting material of Ga.

In the present invention, a more preferable light emitting element is provided by lowering the dislocation of the light emitting layer and also lowering the dislocation of the area where an upper electrode is formed.

As already explained, the dislocation generated when growing a GaN group crystal on the base substrate forms a dislocation line even if crystal layers are sequentially grown, and advances to the upper layer until it reaches the uppermost surface of the laminate. The upper electrode (p-type electrode) is formed on the uppermost surface. Meanwhile, a short-circuit of pn junction, degrades the light emission characteristic of a GaN group light emitting element and shortens the life of the element. The short-circuit is considered to occur when an electrode material enters the dislocation line penetrating the light emitting layer and diffused therein.

In the present invention, the area for forming an electrode is made to have lowered dislocation, whereby the electrode material is kept from entering the dislocation line and the occurrence of a short-circuit can be reduced. As a result, a light emitting element associated with less deterioration of light emission characteristic and having a longer life can be provided.

Hereinafter, in the upper surface of each layer above the mask layer, the area corresponding to the upper part of the mask layer is referred to as the "corresponding masked region" of the concerned plane. Similarly, in the upper surfaces of the upper layers, the area corresponding to the non-masked region is referred to as the "corresponding non-masked region" for explanation.

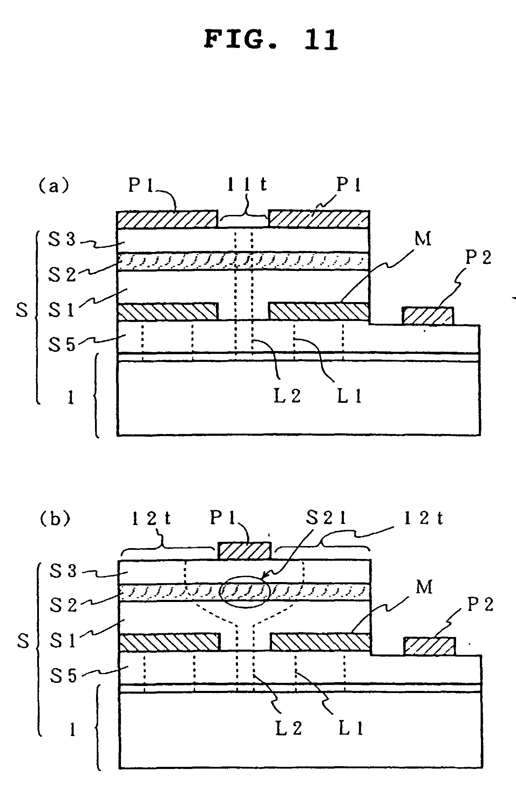

Examples of the combinations of the position of the mask layer to lower the dislocation of the area where an upper electrode is formed, the direction of the dislocation line controlled by the mask layer and a layer covering the mask layer, and the position of the upper electrode are shown in Fig. 11. In every example, a light emitting layer also has lowered dislocation.

In the embodiment of Fig. 11(a), of the double heterojunction structures (S1 - S3), the n-cladding layer S1 on the lower side is a layer covering the mask layer. The mask layer is formed on the upper surface of the n-contact layer S5, and the center portion thereof is a non-masked region. The dislocation line L1 is stopped by the mask layer M. The dislocation line L2 that passed the non-masked region is not bent by layer S1 but advances upward to reach the corresponding non-masked region 11t of the upper electrode forming face. The upper electrode P1 is formed in the corresponding masked region having lowered dislocation within the upper electrode forming face.

In the embodiment of Fig. 11(b), the dislocation line L2 that passed the non-masked region has been bent by the n-cladding layer S1, and reached the corresponding masked region 12t in the upper electrode forming face. The upper electrode P1 is formed in the corresponding non-masked region having lowered dislocation within the upper electrode forming face.

In the embodiment of Fig. 11, the mask layer M constitutes the current constriction structure. In this preferable embodiment, a part of the light emitting layer is made to emit intense light by current constriction, the part is made to have lowered dislocation, and the upper electrode is formed in a low dislocation area. This structure provides an element superior in service life characteristic and having a high luminous efficiency.

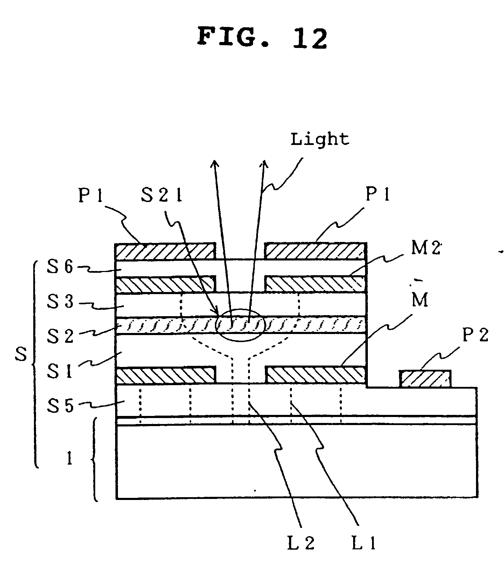

In the embodiment of Fig. 12, the dislocation line L2 is bent by the n-cladding layer S1, and the center portion S21 of the light emitting layer S2 is made to have lowered dislocation. The embodiment up to this stage is the same as in Fig. 11(b). In the embodiment of Fig. 12, a second mask layer M2 is formed in the corresponding masked region between a light emitting layer S2 and the upper electrode, to not prevent light transmission and to stop the bent dislocation line L2. The mask layer M2 is covered with a p-contact layer S6. Consequently, the entirety of the upper electrode forming face has become a low dislocation area. The upper electrode P1 can be formed at an optional position free from prevention of the light emitted from the light emission center. Thus, the luminous intensity of the element can be further increased.

In the present invention, a mask layer is formed within the laminate of a light emitting element, thereby to form a low dislocation area in a light emitting layer and the like. A preferable embodiment of an element in combination with a Bragg reflection layer is provided by the present invention.

Conventionally, a Bragg reflection layer is formed in an element to reflect the light heading to the direction opposite to the side to lead out the light, thereby to reduce loss of light. In the present invention as explained next, a Bragg reflection layer is not merely formed in an element but constructed to provide a peculiar effect by connecting the mask method with the Bragg reflection layer. Taking an LED as an example in the following, an embodiment wherein the Bragg reflection layer is formed on the upper layer side (layer lower than light emitting layer) from the mask layer and an embodiment wherein the Bragg reflection layer is formed on the lower layer side from the mask layer are explained in this order. An embodiment of a GaN group semiconductor laser comprising a reflection layer is also shown.

The Bragg reflection layer has a laminate structure comprising multilayers made from materials having different refractive indices, so that multiple interfaces between such materials are formed. Among others, a multilayer structure made of GaN group crystal is preferable. Particularly, a multilayer laminate structure comprising a desired number of pairs of two GaN group crystal layers constituting a superlattice is preferable because it has a high reflectance.

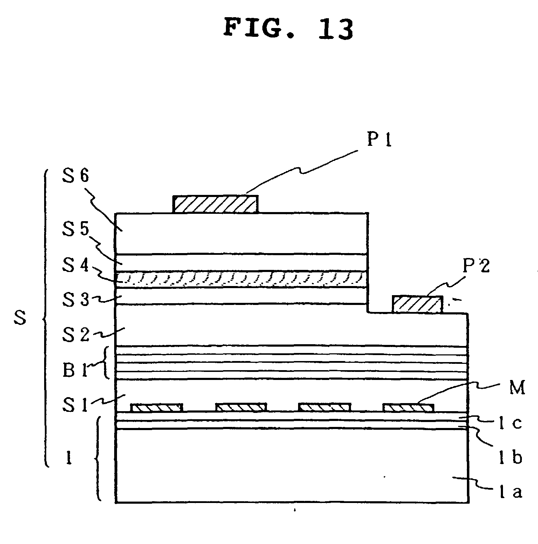

Fig. 13 shows an embodiment further comprising a Bragg reflection layer B1 formed between the layer S1 covering the mask layer M and the light emitting layer S4, in addition to the structure shown in Fig. 1. The dislocation of the light emitting layer S4 has been lowered to allow sufficient emission of ultraviolet rays. The Bragg reflection layer is positioned on the lower layer side from the light emitting layer, reflects upward the light emitted from the light emitting layer toward the lower layer side and leads the light out only with a minimum loss. In addition to this, the upper-lower relation of a Bragg reflection layer set above the layer covering the mask layer results in the inhibition of the degradation of the crystallinity of each GaN group crystal layer constituting the Bragg reflection layer due to the dislocation line. As explained earlier, the area where an upper electrode is formed is made to have lowered dislocation, improving the characteristic of the light emitting element.

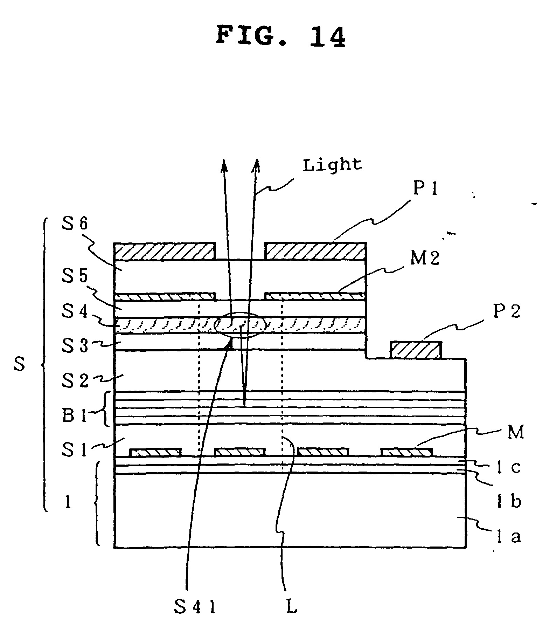

In the embodiment of Fig. 14, the structure of from the base substrate 1 to the double heterojunction structures (S3-S5) is the same as in the embodiment of Fig. 1. In addition, a second mask layer M2 is formed on the upper surface of p-type AlGaN cladding layer S5 and a p-type GaN contact layer S6 covers the mask layer M2. The second mask layer M2 constitutes the current constriction structure, and also stops the dislocation line L coming from the lower side, thereby to lower the dislocation of the area where the upper electrode P1 is formed (area free from prevention of light from going out). The part S41 that emits intense light due to current constriction is made to have lowered dislocation by the mask layer M, improving the luminous efficiency.

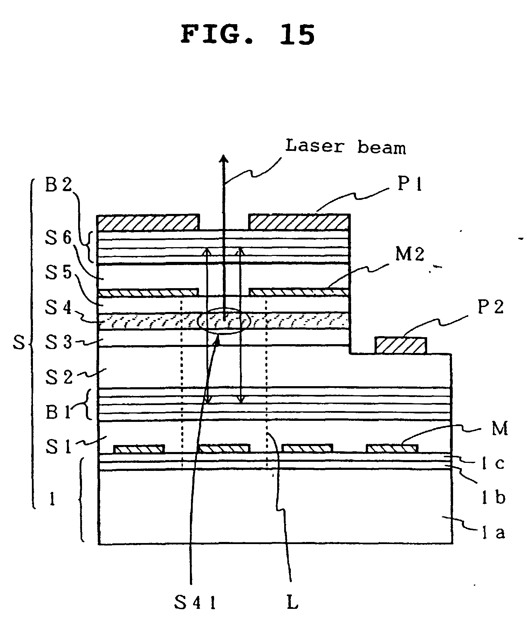

Fig. 15 shows the same structure as in Fig. 14. In addition, a second Bragg reflection layer B2 is formed on the upper layer side from the light emitting layer S4. The second layer B2 forms a resonator together with the Bragg reflection layer B1 on the lower layer side. Thus, a surface light emission type GaN group semiconductor laser is provided. To constitute the resonator, the thickness of the layer between the Bragg reflection layers B1 and B2 is considered. Examples of the Bragg reflection layers B1 and B2 constituting the resonator include a laminate of pairs of GaN layer/AlN layer in the number respectively necessary for resonance and emission. This structure enables production of a preferable ultraviolet laser improved in the degradation of crystallinity by partially lowering the dislocation of the light emitting layer, upper electrode forming face, and resonator, and having a longer service life.

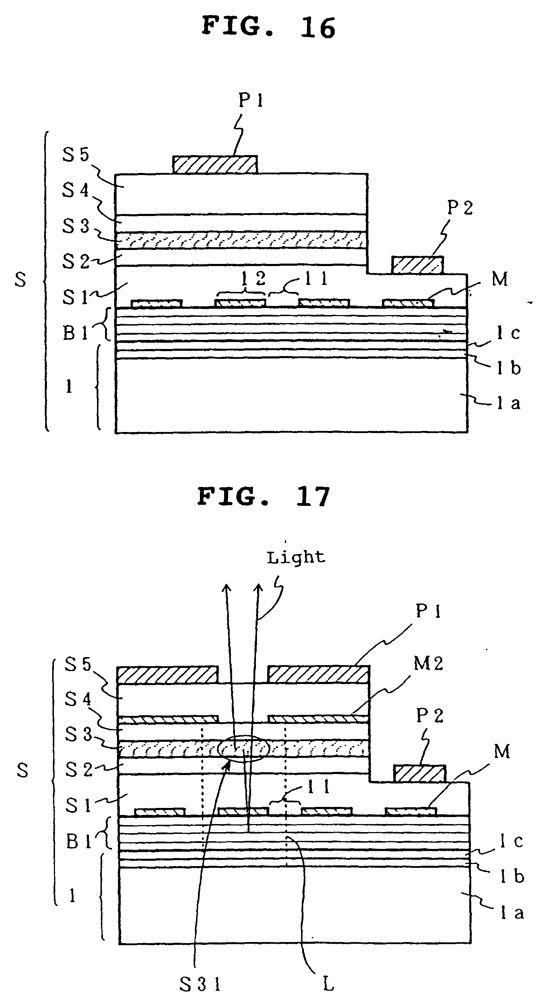

Fig. 16 shows an embodiment comprising a Bragg reflection layer B1 formed on the lower layer side from the mask layer M, conversely from the embodiments of Fig. 13 - Fig. 15. As in the earlier embodiments, the light emitting layer S3 is fully capable of ultraviolet emission after lowering the dislocation. By the limitative upper-lower relationship involving a Bragg reflection layer set on the lower layer side from the mask layer, the mask layer can function as a layer for lowering the dislocation of the upper layer side, and a layer for current constriction. At the same time, it functions as a protective layer to prevent degradation of the Bragg reflection layer on the lower layer side.

By forming a Bragg reflection layer on the lower layer side from the mask layer and a mask layer thereon, the mask layer becomes a protective layer against diffusion of impurities from the upper layer side from the mask layer toward the lower layer, and the damage on the Bragg reflection layer can be reduced. When, for example, an impurity, such as Mg, is diffused to the Bragg reflection layer, the arrangement of the elements constituting the Bragg reflection layer is disturbed, which in turn causes less steep interface and lower reflectance.

Inasmuch as the mask layer can be formed without high temperature as used in the epitaxial growth method, formation of the mask layer itself does not cause thermal damage on the Bragg reflection layer. The mask layer thus formed can be a protective layer against the heat used for forming the upper layers, thus reducing the thermal damage on the Bragg reflection layer.

From the aspect of protection of the Bragg reflection layer by the mask layer, the mask layer provided nearer to the Bragg reflection layer offers a higher effect of a protective layer. As shown in Fig. 16, the structure comprising a Bragg reflection layer B1, a mask layer M, a covering layer S1, and a light emission structure (S2, S3, S4) in this order from the base substrate 1 is a preferable example, because it partially lowers the dislocation of the light emitting layer while preferably protecting the Bragg reflection layer.

In the embodiment of Fig. 17, the structure of from the base substrate 1 to the double heterojunction structure (S2 - S4) is the same as in the embodiment of Fig. 16. The structure on the upper layer side comprises, as in the embodiment of Fig. 14, a second mask layer M2 formed on the upper surface of the p-type AlGaN cladding layer S4, and a p-type GaN contact layer S5 covering the mask layer M2. The second mask layer M2 constitutes the current constriction structure, and also stops the dislocation line L coming from the lower side, thereby to lower the dislocation of the area where the upper electrode P1 is formed (area free from prevention of light from going out). The part S31 that emits intense light due to the current constriction is made to have lowered dislocation by the mask layer M, improving the luminous efficiency.

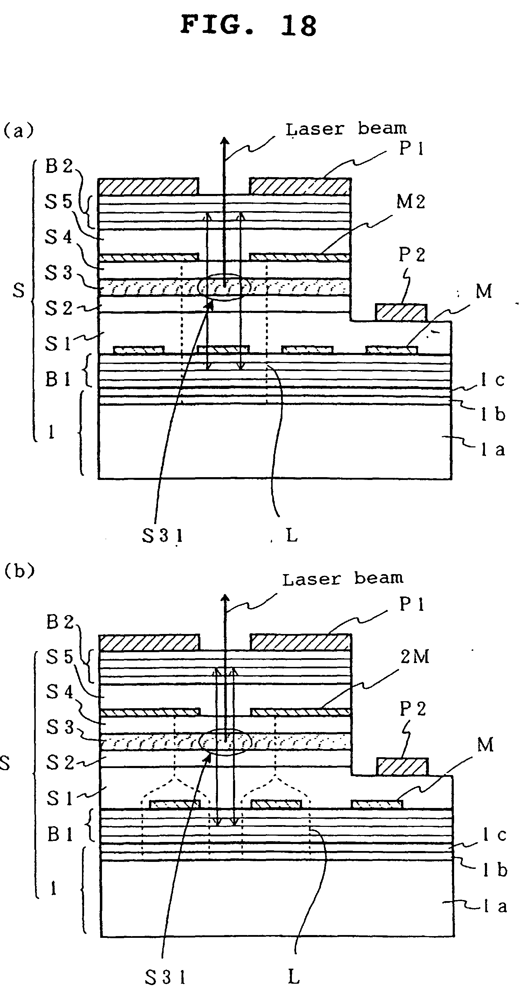

Fig. 18 shows the same structure as in Fig. 17. In addition, a second Bragg reflection layer B2 is formed on the upper layer side from the light emitting layer S3. The second layer B2 forms a resonator together with the Bragg reflection layer B1 on the lower layer side. Thus, a surface light emission type semiconductor laser is provided. Both in Fig. 18(a), (b), a part S31 of the light emitting layer S3 is made to have lowered dislocation, improving the luminous efficiency, and the second mask layer M2 lowers the dislocation of the area where the upper electrode P1 is formed, thus inhibiting shorter service life of an element.

The embodiment of Fig. 18(a) and the embodiment of Fig. 18(b) are different in the growth conditions of a layer covering the mask layer, as explained by referring to Fig. 4, Fig. 5, and therefore, the advance directions of the dislocation lines are also different. In the embodiment of Fig. 18(a), the mask layer M is placed on the optical axis of the resonance, and in the light emitting layer S3, the upper part of the mask layer M has lowered dislocation. In the embodiment of Fig. 18(b), the mask layer M is out of the optical axis of the resonance, and in the light emitting layer S3, the upper part of the non-masked region has lowered dislocation.

**Examples**

**Example 1**

In this Example, a GaN group LED shown in the embodiment of Fig. 1 was actually prepared.

Formation of base substrate

As shown in Fig. 1, a sapphire C face substrate was used as the most basic crystal substrate 1a. This sapphire C face substrate was placed in an MOCVD apparatus, heated to 1100°C in a hydrogen atmosphere for thermal etching. Thereafter, the temperature was lowered to 500°C and trimethylaluminum (hereinafter TMA) as an Al starting material and ammonia as an N starting material were flown to grow an AlN low temperature buffer layer 1b in a thickness of 30 nm.

The temperature was raised to 1000°C and trimethylgallium (TMG) as a Ga starting material and ammonia as an N starting material were flown to grow a GaN layer 1c in a thickness of 2 $\mu$m, to give a base substrate.

Formation of mask layer and layer covering same

This specimen was taken out from the MOCVD apparatus and an $SiO_2$ mask layer M was formed in a sputtering apparatus. The mask layer M had a striped pattern having a thickness of 100 nm and the width of both the masked region and non-masked region of 4 $\mu$m, and the longitudinal direction of the stripe was the 〈1-100〉direction relative to the crystal orientation of GaN group crystal. This specimen was placed in an MOCVD apparatus and heated to 1000°C in a nitrogen atmosphere. TMG and ammonia were flown and GaN crystal was grown to cover the upper surface of the mask layer flat in a thickness of 2 $\mu$m to give layer S1 covering the mask (=n-type contact layer).

In the upper surface of the thus-obtained layer S1 covering the mask, the upper areas corresponding to the masked region and non-masked region were measured for the dislocation density. As a result, the upper areas of the masked region had a lowered dislocation density of $7 \times 10^6$ cm$^{-2}$.

Formation of DH structure

TMG, ammonia and silane as a dopant starting material were flown to grow an n-type AlGaN cladding layer S2 in a thickness of 0.2 $\mu$m. Then, TMG and ammonia were flown to grow a GaN active layer (light emitting layer) S3 in a thickness of 50 nm. The dislocation density of the upper surface of the GaN active layer was measured and it was found that, as in the case of the upper surface of layer S1 covering the mask, the upper surface of the masked region out of the upper surface of the GaN active layer had a lowered dislocation density of $7 \times 10^6$ cm$^{-2}$. Then, TMA, TMG, ammonia and bis(cyclopentadienyl) magnesium (Cp$_2$Mg) as a dopant starting material were flown to grow a p-type AlGaN cladding layer S4 in a thickness of 0.1 $\mu$m, whereby a DH structure as obtained.

Formation of p-type contact layer

TMG, ammonia and Cp$_2$Mg as a dopant starting material were flown to grow a p-type GaN contact layer S5 in a thickness of 0.5 $\mu$m. After the growth, the atmospheric gas was changed to nitrogen and the layer was slowly cooled to room temperature.

Formation of electrode

The sample obtained as in the above was subjected to dry etching to remove a part of the p-type layer and a part of the DH structure from the upper surface of the laminate to expose the upper surface of the n-type GaN layer S1. An n-type electrode (lower electrode) P2 was formed, and a p-type electrode (upper electrode) P1 was formed on the uppermost surface of the laminate, whereby an LED capable of ultraviolet emission was obtained.

Evaluation

This LED was mounted on a To-18 stem table, and the output was measured, which was found to be 1.5 mW at wavelength 362 nm, 20 mA. It was found that the luminous efficiency could be improved by lowering the dislocation even when GaN capable of ultraviolet emission, which is among the $In_aGa_bAl_cN$ compositions, was used as an active layer.

**Example 2**

In this Example, two more sets of a mask layer and a layer covering the mask layer were added to the embodiment of Fig. 6 to give an LED incorporating 4 sets of the mask layer and the covering layer.

Formation of base substrate

In completely the same manner as in Example 1, an AlN low temperature buffer layer 1b and a GaN layer 1c were grown on the base crystal substrate 1a. An $SiO_2$ mask layer M was formed on the surface of the above-mentioned sample under completely the same conditions as in the formation of the mask layer shown in Fig. 1, and a GaN crystal was grown in a thickness of 2 μm to cover the upper surface of the mask layer flat, whereby the layer 1d covering the mask was obtained. In the upper surface of the layer 1d covering the mask, the upper areas corresponding to the masked region and the non-masked region were measured for the dislocation density. As a result, the upper area from the masked region had a lowered dislocation density of $5\times10^6$ cm$^{-2}$, and the upper area from the non-masked region had a dislocation density of $2\times10^9$ cm$^{-2}$ which was of the same level as that of a typical GaN group crystal.

As shown in Fig. 6, in the upper surface of the covering layer 1d, a second mask layer M2 was formed to secure a masked region in an upper area corresponding to the non-masked region formed by the aforementioned mask layer M. This specimen was placed in an MOCVD apparatus and a layer 1e covering the mask layer M2 was obtained as in the case of the layer 1d covering the mask.

In the upper surface of the covering layer 1e thus obtained, the upper areas corresponding to the masked region and the non-masked region formed by the second mask layer M2 were measured for the dislocation density. As a result, the upper area from the masked region had a dislocation density of $7\times10^6$ cm$^{-2}$, and the upper area from the non-masked region had a dislocation density of $5\times10^6$ cm$^{-2}$.

In the same manner as in the above-mentioned second mask layer M2 and following the formation pattern of making a mask layer to cover a non-masked region defined by a mask layer formed within a layer covering the mask layer, on an upper surface of the covering layer, a third mask layer and a layer covering this mask layer, and further, a fourth mask layer and a layer covering this mask layer (these not shown in Fig. 6) were sequentially layered in 4 sets in all to give a base substrate 1.

The upper surface of the above-mentioned fourth covering layer, namely, in the upper surface of the base substrate 1, the upper areas corresponding to the masked region and the non-masked region formed by the fourth mask layer were measured for the dislocation density. As a result, these upper areas had a common density of $2\times10^3$ cm$^{-2}$.

Formation of element structure

Under the same conditions as in Example 1, an n-type GaN layer S1 was grown in a thickness of 1 μm, an n-type AlGaN cladding layer S2 and a GaN active layer (light emitting layer) S3 were grown on the base substrate 1. The upper surface of the GaN active layer was measured for the dislocation density. Like the upper surface of the base substrate, in the upper surface of the GaN active layer, the upper areas from the masked region and the non-masked region formed by the fourth mask layer had a common dislocation density of $2\times10^3$ cm$^{-2}$. A p-type AlGaN cladding layer S4 was grown to give a DH structure. A contact layer S5, an n-type electrode (lower electrode) P2, and a p-type electrode (upper electrode) P1 were formed, whereby an LED capable of ultraviolet emission was obtained.

Evaluation

This LED was mounted on a To-18 stem table, and the output was measured, which was found to be 5 mW at wavelength 362 nm, 20 mA. It was found that an output similar to that of a blue LED comprising an InGaN active layer was obtainable using a GaN active layer even in an ultraviolet range at 362 nm.

**Comparative Example**

As a Comparative Example of Example 1, a typical base substrate comprising three layers of a sapphire C face substrate 1a, an AlN low temperature buffer layer 1b (thickness 30 nm) and a GaN layer 1c (thickness 2 μm) used in Example 1 was used. The layers S1-S5 were formed thereon as in Example 2 to give a typical conventional LED without a structure for lowering the dislocation. The dislocation density of the GaN light emitting layer of this LED was equally $2\times10^9$ cm$^{-2}$

throughout the upper surface of the light emitting layer. The output of this LED was measured and found to be 0.2 mW at 20 mA with a low luminous efficiency.

## Example 3

In this Example, the mask method was used for the production of a light emitting element. The mask layer was colored and GaN crystal was grown to confirm if the mask layer could be distinguished.

The most basic crystal substrate 1a was a sapphire C face substrate having a diameter of 2 inches and a thickness of 330 $\mu$m. Under the same conditions as in Example 1, a base substrate 1 comprising a sapphire C face substrate, an AlN low temperature buffer layer and a GaN layer was prepared.

### Coloring of mask layer

In a sputtering apparatus, a mask layer ($SiO_2$ layer, thickness 100 nm) covering the entire base substrate surface was formed. Iron chloride was brought into contact with the surface of the $SiO_2$ layer and heat treated in an inert gas at 1150°C to allow heat dispersion of Fe as a distinguishing substance in an $SiO_2$ layer. As a result, the $SiO_2$ layer was colored brown.

### Patterning of mask layer

A photosensitive resist was patterned by photolithography, and a striped mask layer was formed by etching. The longitudinal direction of the stripe was the ⟨11-20⟩ direction of the growing GaN group crystal. As a result, a substrate for GaN group crystal growth was obtained.

### Growth of GaN crystal layer

The above-mentioned substrate was placed in an MOCVD apparatus, heated to 1000°C in a hydrogen atmosphere (containing ammonia). TMG and ammonia were flown for 30 min to grow GaN crystal to be used as a GaN crystal substrate. The GaN crystal was first grown to have a pyramidal shape in the non-masked region, and flattened at about 10 $\mu$m thickness from the base substrate face. The mask layer could be clearly distinguished due to the coloring in brown, even if embedded in the GaN crystal layer.

### Formation of second mask layer

Using the mask layer (colored) inside the GaN crystal layer as the standard, the corresponding non-masked region on the upper surface of the GaN crystal layer was covered to form the second mask layer in a striped pattern. The mask layer on the lower layer side was a fine processing standard.

### Growth of second GaN crystal layer

By the MOCVD method, a GaN crystal layer was grown until it embedded the second mask layer. As a result, the dislocation line that started from the interface between the substrate and the buffer layer and extended toward the upper layer side was sufficiently inhibited by the two layers (two phases) of the mask layers. Thus, the second GaN crystal layer had sufficiently lowered dislocation.

## Example 4

In this Example, a tungsten layer was formed as a non-transmission layer on the lower layer of the mask layer to make the mask layer distinguishable, as shown in Fig. 8. GaN crystal was grown to confirm the distinguishability of the mask layer.

### Formation of base substrate

Under the same conditions as in Example 3, a base substrate 1 consisting of a sapphire C face substrate, an AlN low temperature buffer layer and a GaN layer was formed.

### Formation of non-transmission layer, $SiO_2$ layer

A tungsten layer was formed on a base substrate 1 by deposition, and a 100 nm thick $SiO_2$ layer was formed by sputtering. Thereafter, a photosensitive resist was patterned by photolithography, followed by etching to give a striped mask layer M consisting of an $SiO_2$ layer m2/tungsten layer m11, as shown in Fig. 8(a). The longitudinal direction of the stripe was the ⟨11-20⟩ direction of the growing GaN group crystal. As a result, a substrate for GaN group crystal growth was obtained.

### Growth and evaluation of GaN crystal layer

In the same manner as in Example 3, a GaN crystal was grown until it covered the upper surface of the mask layer and used as a GaN crystal substrate. The mask layer embedded in the GaN crystal layer of the obtained GaN crystal substrate could show the position clearly and made a standard for preferable positioning during processing of the part having lowered dislocation in the GaN crystal layer.

## Example 5

This Example is a variation of Example 4, wherein the non-transmission layer was a Bragg reflection layer.

Formation of Bragg reflection layer and SiO$_2$ layer

A Bragg reflection layer having a reflection peak wavelength of 450 nm was laminated by the MOCVD method as a GaN/Al$_{0.1}$Ga$_{0.9}$N$_4$ pair multilayer film on the base substrate 1, similar to that obtained in Example 4, to cover the entire upper surface of the base substrate. The total thickness of the Bragg reflection layer was 366 nm. Using a sputtering apparatus, a 100 nm thick SiO$_2$ layer was formed to cover the entire upper surface of the Bragg reflection layer. In the same manner as in Example 4, etching was applied to give a striped mask layer M consisting of SiO$_2$ layer m2/Bragg reflection layer m12, as shown in Fig. 8(b).

Growth of GaN crystal

This specimen was placed in an MOCVD apparatus and a GaN crystal was grown until it covered the mask layer under the same conditions as in Example 4 to give a GaN crystal substrate. The GaN crystal first grew in the non-masked region to form a pyramidal shape and became flat at a thickness of about 10 μm from the base substrate plane.

Growth and evaluation of GaN crystal layer

In the same manner as in Example 4, a GaN crystal was grown until it covered the upper surface of the mask layer and used as a GaN crystal substrate. The mask layer embedded in the GaN crystal layer was visually pale purple, which allowed clear identification of the position of the mask layer particularly upon irradiation of 400 nm light and observation with a photography apparatus. In the same manner as in Example 3, a second mask layer was formed to give a crystal having sufficiently low dislocation.

**Example 6**

In this Example, a GaN group LED having the same structure as in Example 1 was prepared, wherein an active layer was GaN, and layers other than the active layer, such as surface layer of the base substrate and a layer covering the mask, were AlGaN. The growth conditions were almost the same as in Example 1 except the composition ratio of each layer.

Formation of base substrate

By the same method as used in Example 1, an AlN low temperature buffer layer 1b was grown in a thickness of 30 nm using a sapphire C face substrate as a crystal substrate 1a, and an Al$_{0.05}$Ga$_{0.95}$N layer 1c was grown in a thickness of 2 μm, whereby a base substrate 1 was obtained.
In the same manner as in Example 1, an SiO$_2$ mask layer M was formed. As the layer S1 covering the mask (=n-type contact layer), an Al$_{0.05}$Ga$_{0.95}$N crystal layer was grown in a thickness of 6 μm. The corresponding masked region on the upper surface of layer S1 had a lowered dislocation density of $7\times10^6$ cm$^{-2}$.
An n-type Al$_{0.1}$Ga$_{0.9}$N cladding layer S2 (thickness 0.2 μm), a GaN active layer S3 (thickness 50 nm) and a p-type Al$_{0.1}$Ga$_{0.9}$N cladding layer S4 (thickness 0.1 μm) were grown to give a DH structure. A p-type Al$_{0.05}$Ga$_{0.95}$N contact layer S5 was grown in a thickness of 0.5 μm, and a p-type electrode (upper electrode) P1 and an n-type electrode (lower electrode) P2 were formed in the same manner as in Example 1 to give an LED capable of ultraviolet emission.
The dislocation density of the upper surface of the active layer was measured during the growth process. The corresponding masked region had a lowered dislocation density of $7\times10^6$ cm$^{-2}$.

Evaluation

This LED was mounted on a To-18 stem table, and the output was measured, which was found to be 1.5 mW at wavelength 362 nm, 20 mA as in Example 1. The occurrence of cracks in each layer was observed with a microscopy, but no cracks were found. The effect provided by forming all the major layers with AlGaN was confirmed.

**Example 7**

This Example shows an embodiment of the mask method explained by referring to Fig. 10, wherein GaN group crystal was actually grown using GaN as the first layer and AlGaN as the second layer.

Formation of base substrate

As shown in Fig. 10, an AlGaN low temperature buffer layer 1b was grown and then an n-type Al$_{0.1}$Ga$_{0.9}$N layer 1c was grown in a thickness of 2 μm on a sapphire C face substrate 1a having a diameter of 2 inches to give a base substrate 1.

Formation of mask layer

An SiO$_2$ mask layer M was formed on a substrate surface of the base substrate 1 in a sputtering apparatus. The SiO$_2$ mask layer was patterned in stripes, wherein the longitudinal direction of the mask layer was the 〈1-100〉 direction, the thickness of the mask layer was 0.1 μm, the width of the mask layer was 4 μm, and the width of the non-masked region was 4 μm.

Formation of first layer

This specimen was placed in an MOCVD apparatus, and heated to 1000°C in a nitrogen atmosphere, and TMG, ammonia and silane were flown for 30 min. With the non-masked region as the starting point of the crystal growth, an n-GaN layer was grown as the first layer t1. The growth was continued until the time point when the mask layer was covered with GaN. As shown in Fig. 10, the thickness T of the first layer t1 from the upper surface of the base substrate in the non-masked region was 1.8 μm.

Formation of second layer

In addition to TMG, ammonia and silane, TMA was flown at an increasing flow amount (initial value 0) that changed the Al composition from 0 to 0.2 throughout the layer thickness of the second layer (i.e., the second layer comprised GaN near the lower surface and $Al_{0.2}Ga_{0.8}N$ near the upper surface), and the growth was continued until the total layer thickness reached 3 μm to give a second layer t2, which was used as a GaN group crystal substrate.

The AlGaN crystal of the second layer had an area having low dislocation on the upper part of the mask layer. There was no occurrence of cracks in a 2 inch wafer.

Example 8

In this Example, a light emitting part was further formed on the GaN group crystal substrate obtained in the above-mentioned Example 7 to give an ultraviolet ray (370 nm) emitting element.

Formation of DH structure

The second layer ($Al_{0.2}Ga_{0.8}N$ near the upper surface) of the GaN group crystal substrate obtained in the above-mentioned Example 7 was used as an n-type cladding layer, and an InGaN layer (50 nm) was formed on the surface thereof as an active layer. Then, an $Al_{0.2}Ga_{0.8}N$ layer was formed in a thickness of 0.1 μm as a p-type cladding layer.

Formation of electrode etc.

A p-type $Al_{0.05}Ga_{0.95}N$ layer was grown in a thickness of 0.2 μm as a contact layer on a p-type cladding layer. A p-type electrode was formed on the contact layer, and an n-type cladding layer (second layer of GaN group crystal substrate) was partially exposed by dry etching to form an n-type electrode, whereby an LED was completed.

Evaluation

This LED was mounted on a To-18 stem table, and the output was measured, which was found to be 1 mW at wavelength 370 nm, 20 mA.

Example 9

In this Example, a GaN group light emitting element as shown in Fig. 11(b) was prepared. The dislocation density of the light emitting layer S2 was partially lowered by the mask layer M and the layer S1 covering the mask. The part in question had a structure that allowed intense light emission by the current constriction of the mask layer M.

The longitudinal direction of the mask layer was formed to be the ⟨11-20⟩ direction and the growth rate in the C axis direction (layer thickness direction) was increased during the growth of the layer S1 covering the mask, whereby the dislocation line L2 was bent toward the masked region side. The dislocation density of the corresponding non-masked region of the upper electrode forming face was lowered and an upper electrode P1 was formed thereon.

As a Comparative Example of this Example, an LED was prepared in completely the same manner as in this Example except that an upper electrode was formed within the corresponding masked region 12t in the upper electrode forming face shown in Fig. 11(b), and the properties of the both LEDs were compared.

As a result, the luminous intensity was 60 mcd for the sample of this Example and 80 mcd for the sample of Comparative Example, and the life of the element was 10000 hr for the sample of this Example and 2000 hr for the sample of Comparative Example.

Example 10

In this Example, an LED as shown in Fig. 12 was prepared. In addition to Example 9, a second mask layer M2 having a thickness of 100 nm was formed using $SiO_2$ as a material in this Example, in the corresponding masked region of the upper surface of the p-GaN cladding layer S3, whereby the advance of the dislocation line was stopped. A p-type GaN crystal was grown in a thickness of 2 μm as a layer covering the second mask layer M2 to give a p-GaN contact layer S6. The upper electrode P1 was formed in the area outside the upper part from the light emission part S21, to not prevent the light from going out.

In this light emitting element, a light emission part S21 and an upper electrode showed low dislocation, and the upper electrode had a structure that did not prevent the light from going out. Therefore, the luminous intensity was as high as 180 mcd. While the light emitting layer may degrade due to the current constriction structure, invasion of an electrode material into the dislocation line was sufficiently prohibited. Thus, the light emitting element had a long service life of 7000 hr, and was preferable in terms of luminous intensity and service life.

## Example 11

In this Example, an LED as shown in Fig. 13 was prepared.

In the same manner as in Example 1, a sapphire C face substrate was used as a crystal substrate 1a, an AlN low temperature buffer layer 1b was grown in a thickness of 30 nm, and a GaN layer 1c was grown in a thickness of 3 μm to give a base substrate 1. This specimen was taken out from the MOCVD apparatus, and a striped SiO₂ mask layer M having a thickness of 100 nm was prepared by a sputtering apparatus. The longitudinal direction of the mask layer M was the 〈1-100〉direction. An n-type GaN crystal was grown in a thickness of 5 μm as a layer covering the mask layer to give an n-type GaN layer S1.

Formation of Bragg reflection layer

Twenty sets of 2 layer-one pair GaN layer/AlN layer, each layer having a thickness of 1/4 of the light emitting wavelength, were laminated to give a Bragg reflection layer B1. Each layer was formed by the MOCVD method.

Formation of element structure

An n-type GaN contact layer S2 was grown in a thickness of 2 μm. An n-type AlGaN cladding layer S3 was grown in a thickness of 0.8 μm, the growth atmospheric gas was changed from hydrogen to nitrogen and the growth temperature was lowered to 700°C while flowing ammonia. Trimethylindium (TMI) as an In starting material, TMG and ammonia were flown to grow an InGaN active layer S4 in a thickness of 3 nm, the temperature was raised to 1000°C, the growth atmospheric gas was changed from nitrogen to hydrogen, and a p-type AlGaN cladding layer S5 was grown in a thickness of 0.1 μm, whereby a DH structure was obtained. Further, a p-type GaN contact layer S6 was grown in a thickness of 0.5 μm, and a p-type electrode P1 and an n-type electrode P2 were formed to give an LED.

As a Comparative Example of this Example, an embodiment shown in Fig. 13 was prepared except that the mask layer M and the layer S1 covering the mask layer M were not formed and the dislocation density of the Bragg reflection layer B1 was not lowered.

Both LEDs were mounted on a To-18 stem table, and the output was measured at 20 mA. The output of the sample of this Example was 8 mW, the service life thereof was 5000 hr, the output of the sample of Comparative Example was 2 mW and the service life thereof was 500 hr. It was found that the light emitting element of the present invention comprising a Bragg reflection layer having lowered dislocation had superior characteristics in terms of output and service life.

## Example 12

In this Example, a GaN group light emitting element as shown in the embodiment of Fig. 14 was prepared. The laminate structure was completely the same as in Example 11 except the following points.

(1) A mask layer M2 was formed on the upper surface of the p-type AlGaN cladding layer S5, and current constriction was applied to a light emitting layer. The part S41 that emitted intense light due to the current constriction corresponded to the upper part of the mask layer M and this part was made to have lowered dislocation. The p-type GaN contact layer S6 covered the mask layer M2.

(2) The upper electrode P1 was formed except the upper part of the light emitting part S41 to not prevent the light from going out.

The LED obtained in this Example was measured in completely the same manner as in Example 11 for the output. As a result, the output was 15 mW and the service life was 5000 hr. As compared to Example 11, the input was higher and the embodiment was more preferable.

## Example 13

In this Example, an LED as shown in the embodiment of Fig. 16 was prepared.

A Bragg reflection layer B1 (a laminate of 20 sets of 2 layer-one pair GaN layer/AlN layer, each layer having a thickness of 1/4 of the light emitting wavelength) was formed on a base substrate 1 as obtained in Example 11. Each layer of the Bragg reflection layer was formed by the MOCVD method

Formation of mask layer and layer covering same

A 100 nm thick striped SiO₂ mask layer M was formed on the upper surface of the Bragg reflection layer B1 in a sputtering apparatus. The longitudinal direction of the mask layer M was the 〈1-100〉direction relative to the crystal orientation of the Bragg reflection layer. This specimen was placed in an MOCVD apparatus, and heated to 1000°C in a hydrogen atmosphere. TMG, ammonia and silane as a dopant starting material were flown to grow an n-type GaN crystal layer S1 (thickness 5 μm) as a layer covering the mask layer.

Formation of element structure

In the same manner as in other Examples, an n-type AlGaN cladding layer S2 was grown in a thickness of 0.8 μm, an InGaN active layer S3 was grown in a thickness of 3 nm and a p-type AlGaN cladding layer S4 was grown in a thickness of 0.1 μm to give a DH structure. A p-type GaN contact layer S5 was grown in a thickness of 0.5 μm, and a p-type electrode P1 and an n-type electrode P2 were formed to give an LED.

As a Comparative Example of this Example, a structure without a mask layer M or protection of the Bragg reflection layer B1 was prepared.

The both LEDs were mounted on a To-18 stem table, and the output was measured at 20 mA. The output of the sample of this Example was 8 mW, the service life thereof was 5000 hr, the output of the sample of Comparative Example was 2 mW and the service life thereof was 500 hr. It was found that the light emitting element of the present invention had superior characteristics in terms of both output and service life.

## Example 14

In this Example, an LED as shown in the embodiment of Fig. 17 was prepared. The laminate structure was completely the same as in Example 13 except the following points.

(1) A mask layer M2 was formed on the upper surface of the p-type AlGaN cladding layer S4, and current constriction was applied to a light emitting layer. The part S31 that emitted intense light due to the current constriction corresponded to the upper part from the mask layer M and this part was made to have lowered dislocation. The p-type GaN contact layer S5 covered the mask layer M2.

(2) The upper electrode P1 was formed except the upper part of the light emission part S31 to not prevent the light from going out.

The LED obtained in this Example was measured in completely the same manner as in Example 13 for the output. As a result, the output was 15 mW and the service life was 5000 hr. As compared to Example 13, the input was higher and the embodiment was more preferable.

## Example 15

In this Example, Example 1 was partially modified, wherein the width of the mask layer was set narrow to 0.5 μm to inhibit precipitation of polycrystal on the mask layer. The layer covering the mask layer and the n-type contact layer thereon were different layers. Except these, a GaN group LED having the structure similar to Example 1, Fig. 1, was prepared.

### Formation of base substrate

In the same manner as in Example 1 except that, in Example 1 (formation of base substrate), TMG, TMA and ammonia were fed to grow an AlGaN layer in a thickness of 2 μm after growth of the AlN low temperature buffer layer, a base substrate was obtained.

### Formation of mask layer and layer covering same

In the same manner as in Example 1 except that, in Example 1 (formation of mask layer and layer covering same), the width of the masked region and the non-masked region was commonly set to 0.5 μm, a mask layer was formed. This specimen was placed in an MOCVD apparatus, and heated to 1000°C in a hydrogen atmosphere. TMG, TMA and ammonia were flown to grow $Al_{0.5}Ga_{0.5}N$ in a thickness of 1 μm to cover the upper surface of the mask layer flat, whereby a layer covering the mask was obtained.

The growth of a specimen for observation, which had been formed separately in completely the same manner as in this Example, was stopped at this point and the condition before covering the mask was observed by SEM. As a result, precipitation of polycrystal on the mask was not observed. The specimen for this Example was continuously grown without interruption.

In the upper surface of a layer covering the mask layer thus obtained, the upper areas corresponding to the masked region and the non-masked region were measured for the dislocation density. As a result, the upper area from the masked region had a lowered dislocation density of $7 \times 10^6$ cm$^{-2}$. Then, silane as a dopant starting material was added to TMG, TMA and ammonia, and an n-type $Al_{0.1}Ga_{0.9}N$ contact layer was grown in a thickness of 2 μm.

### Formation of light emitting layer

Silane as a dopant starting material was added to TMG, TMA and ammonia, and an n-type $Al_{0.15}Ga_{0.85}N$ cladding layer was grown in a thickness of 0.2 μm. Then, multiple quantum well active layers made of AlGaN/InGaAlN were formed in 5 pairs. The dislocation density of the upper face from the multiple quantum well active layer made of AlGaN/InGaAlN was measured. As in the upper surface of the layer covering the mask layer, in the upper face of the active layer, the upper area from the masked region had a lowered dislocation density of $7 \times 10^6$ cm$^{-2}$. Then, $Cp_2Mg$ as a dopant starting material was added to TMG, TMA and ammonia and a p-type $Al_{0.15}Ga_{0.85}N$ cladding layer was grown in a thickness of 0.1 μm.

### Formation of p-type contact layer

TMG, TMA, ammonia and $Cp_2Mg$ as a dopant starting material were flown to grow a p-type $Al_{0.1}Ga_{0.9}N$ contact layer in a thickness of 0.1 μm. After the growth, the specimen was annealed in a nitrogen atmosphere.

### Evaluation

This LED was mounted on a To-18 stem table, and the output was measured, which was found to be 5 mW at wavelength 380 nm, 20 mA.

**Example 16**

In this Example, the group III feed gas to be fed for the growth of a layer covering the mask by MOCVD was replaced for an alkyl chloride compound of a group III element, and an element was actually formed. The layer covering the mask and the n-type contact layer thereon were different layers. Except these, a GaN group LED having the same structure as in Example 15 was prepared.

In the same manner as in Example 15, a base substrate was formed. In Example 15 (formation of mask layer and layer covering same), the width of the masked region and the non-masked region was commonly set to 4 μm. The composition of the layer covering the mask layer was set to $Al_{0.05}Ga_{0.95}N$ and this layer was grown in the same manner as in Example 15, except that diethylgallium chloride (DEGaCl) was used as a Ga starting material and diethylaluminium chloride (DEAlCl) was used as an Al starting material, in a thickness of 1 μm to cover flat the upper surface of the mask layer to give a layer covering the mask.

The growth of a specimen for observation, which had been formed separately in completely the same manner as in this Example, was stopped at this point and the condition before covering the mask was observed by SEM. As a result, precipitation of polycrystal on the mask was not observed. The specimen for this Example was continuously grown without interruption.

In the upper surface of a layer covering the mask thus obtained, the upper areas corresponding to the masked region and the non-masked region were measured for the dislocation density. As a result, the upper area from the masked region had a lowered dislocation density of $7 \times 10^6$ cm$^{-2}$. Thereafter, an LED was obtained in the same manner as in Example 15. This LED was mounted on a To-18 stem table, and the output was measured, which was found to be 5 mW at wavelength 380 nm, 20 mA.

**Industrial Applicability**

According to the present invention, a light emitting element capable of emitting ultraviolet rays at a sufficiently high luminous efficiency can be obtained, even by the use of $In_aGa_bAl_cN$ (e.g., GaN, AlGaN), made to have a composition capable of ultraviolet emission, as a light emitting layer. In addition, by forming the entire thick films of the GaN group crystal layer with AlGaN, occurrence of cracks can be inhibited, and the problem of absorption of light emitted from the light emitting layer by other layers can be overcome. Furthermore, by lowering the dislocation of the upper electrode forming face, an electrode material is kept from entering the dislocation line, thereby reducing occurrence of a short-circuit, which in turn results in less degradation of light emission characteristic and an ultraviolet light emitting element having a longer life. Moreover, by solving the problem of Al composition associated with the mask method and clarifying the preferable combination of the mask layer and the Bragg reflection layer, a superior ultraviolet light emitting element can be provided.

This application is based on patent application Nos. 337039/1997, 339780/1997, 307677/1997, 327927/1997, 327907/1997, 179339/1998, 198514/1998 and 236845/1998 filed in Japan, the contents of which are hereby incorporated by reference.

**Claims**

1.   A GaN group semiconductor light emitting element comprising a light emitting layer made of $In_aGa_bAl_cN$ (0≦a≦1, 0≦b≦1, 0≦c≦1, a+b+c=1 ) which emits ultraviolet rays, and which comprises a part having lowered dislocation.

2.   The light emitting element of claim 1, wherein the $In_aGa_bAl_cN$ is $Al_xGa_{(1-x)}N$ (0≦x<1).

3.   The light emitting element of claim 1, wherein the part having lowered dislocation in the light emitting layer has a dislocation density of not more than $10^7$ cm$^{-2}$.

4.   The light emitting element of claim 1, which comprises GaN group crystal layers all made of $Al_yGa_{(1-y)}N$ (0<y≦1) wherein the Al composition y satisfies [energy Eg1 of light emitted from the light emitting layer] < [band gap energy Eg2 of layer(s) other than the light emitting layer], except a material of an active layer when the active layer is the light emitting layer.

5.   The light emitting element of claim 1, which has a structure comprising a laminate of plural GaN group crystal layers, inclusive of a light emitting layer, successively grown on one another on a base substrate as the lowermost layer, the substrate permitting growth of GaN group crystal with the C axis as the thickness direction, and a p-type electrode and an n-type electrode formed on the laminate, wherein

the lowered dislocation of the light emitting layer is achieved by a mask layer and a layer covering the mask layer, that are formed between the base substrate and the light emitting layer,
the mask layer and the layer covering the mask layer being formed in the laminating direction in one or more pairs,
the mask layer being partially formed to define a masked region and a non-masked region on the surface where the mask layer is formed,

the mask layer being made from a material substantially free of growth of GaN group crystal from its surface, and

the layer covering the mask layer being a GaN group crystal layer grown from the non-masked region as a growth starting plane until it has covered the upper surface of the mask layer.

6. The light emitting element of claim 5, wherein the layer covering the mask layer is formed while controlling the ratio of the growth rate in the C axis direction and the growth rate in the direction perpendicular to the C axis, and the ratio of the two growth rates is controlled by combining a pattern of the mask layer, a crystal growth method and an atmospheric gas during the crystal growth.

7. The light emitting element of claim 5, wherein the mask layer has a striped pattern formed by setting strip-like mask layers in stripes and the longitudinal direction of the stripe extends in the ⟨11-20⟩ direction or ⟨1-100⟩ direction relative to the GaN group crystal formed on the base substrate.

8. The light emitting element of claim 5, wherein the mask layer and the layer covering the mask layer are set in the laminating direction in two or more pairs, the mask layer of each pair having a striped pattern formed by setting strip-like mask layers in stripes and the pattern satisfying $\{(W1-W2)/(W1+W2)\} \geqq 0.1$ wherein W1 is the width of the strip-like mask layer and W2 is the width of a strip-like non-masked region.

9. The light emitting element of claim 5, wherein the mask layer has a striped pattern formed by setting strip-like mask layers in stripes and the strip-like mask layer has a width of 0.01 μm - 1 μm.

10. The light emitting element of claim 5, wherein the mask layer affords current constriction, the current constriction concentrating the current to a part in the light emitting layer, where the dislocation has been lowered.

11. The light emitting element of claim 1, which has a structure comprising a laminate of plural GaN group crystal layers, inclusive of a light emitting layer, successively grown on one another on a base substrate as the lowermost layer, the substrate permitting growth of GaN group crystal with the C axis as the thickness direction, and a p-type electrode and an n-type electrode formed on the laminate, wherein the lowered dislocation of the light emitting layer is achieved by using the following base substrate (A) as the base substrate:

(A) a base substrate having at least a surface layer of a GaN group crystal layer, wherein at least a part or the entirety of the surface layer has lowered dislocation, and at least a surface layer of the following GaN group crystal substrate (B) is utilized:

(B) a laminate of GaN group crystal layers successively grown on a substrate as the lowermost layer, the subdstrate permitting growth of GaN group crystal with the C axis as the thickness direction,

the mask layer and the layer covering the mask layer being formed in the laminating direction in one or more pairs,

the mask layer being partially formed to define a masked region and a non-masked region on the surface where the mask layer is formed,

the mask layer being made from a material substantially free of growth of GaN group crystal from a surface thereof, and

the layer covering the mask layer being a GaN group crystal layer grown from the non-masked region as a growth starting plane until it has covered the upper surface of the mask layer.

12. The light emitting element of claim 11, wherein the layer covering the mask layer of the GaN group crystal substrate of the (B) is formed while controlling the ratio of the growth rate in the C axis direction and the growth rate in the direction perpendicular to the C axis, and the ratio of the two growth rates is controlled by combining a forming pattern of the mask layer, a crystal growth method and an atmospheric gas during the crystal growth.

13. The light emitting element of claim 5, wherein, of the both electrodes, an upper electrode to be formed on the upper layer side from the light emitting layer is formed in an area having lowered dislocation, which is in an electrode forming face where the upper electrode is to be formed.

14. The light emitting element of claim 5, further comprising a Bragg reflection layer formed between the light emitting layer and the layer covering the mask layer.

15. The light emitting element of claim 5, further comprising a Bragg reflection layer formed on the lower layer side from the mask layer.

16. The light emitting element of claim 5, further comprising a Bragg reflection layer formed on the upper layer side from the light emitting layer, wherein the Bragg reflection layer and a Bragg reflection layer formed on the lower layer side from the light emitting layer constitute a resonator to resonate the light emitted from the light emitting layer.

17. The light emitting element of claim 5, wherein the mask layer comprises a distinguishing substance that prevents transmission of a light having a wavelength selected from ultraviolet rays to infrared rays and that makes the mask layer visually or optically distinguishable, the distinguishing substance capable of retaining the distinguishing power imparted to the mask layer even upon exposure to the GaN group semiconductor crystal growth conditions in the mask layer.

18. The light emitting element of claim 17, wherein the distinguishing substance is at least one element selected from Fe, Cr and Nd.

19. The light emitting element of claim 5, further comprising a non-transmission layer that prevents transmission of a light having a wavelength selected from ultraviolet rays to infrared rays and that is formed, in accordance with the mask layer forming pattern, between a surface where the mask layer is formed and the mask layer, by which the mask layer is made visually or optically distinguishable, the non-transmission layer being made from a material capable of standing the GaN group semiconductor crystal growth conditions, and capable of retaining the property to inhibit transmission of said light even upon exposure to the GaN group semiconductor crystal growth conditions.

20. The light emitting element of claim 19, wherein the non-transmission layer comprises a Bragg reflection layer.

21. The light emitting element of claim 19, wherein the non-transmission layer is made from a material that prevents transmission of a partial or entire wavelength light in the visible region.

22. The light emitting element of claim 5, wherein the layer covering the mask layer is a first GaN group crystal layer, and a second GaN group crystal layer is grown thereon, the first GaN group crystal layer has an Al composition of substantially nil, and the second GaN group crystal layer comprises a layer having an increasing Al composition with an increasing layer thickness from the boundary of the first GaN group crystal layer.

23. The light emitting element of claim 22, wherein the layer having an increasing Al composition in the second GaN group crystal layer has an initial Al composition value of not more than 0.01.

24. The light emitting element of claim 22, wherein the first GaN group crystal layer is a GaN crystal layer and the second GaN group crystal layer is an AlGaN crystal layer.

25. A production method of GaN group crystal, which comprises the steps of

forming a mask layer on a crystal surface where a GaN group crystal can grow, such that a masked region and a non-masked region are defined,

the mask layer being made from a material substantially free of GaN group crystal growth from its surface, and

growing a GaN group crystal from the non-masked region as a growth starting plane until it covers the upper surface of the mask layer by the vapor phase growth method, wherein, of the feed gases fed for the crystal growth, an alkyl chloride compound of a group III element is used as a group III feed gas when forming the layer covering the mask layer.

26. The production method of GaN group crystal according to claim 25, wherein the mask layer and the layer covering the mask layer are those included in the GaN group semiconductor light emitting element of any of claims 5 to 23.

# FIG. 1

# FIG. 2

(a)

30  11  12  M

1

(b)

Dislocation line  M  30

12  11

1

(c)

Dislocation line  M  30

1

# FIG. 3

(a)

(b)

# FIG. 4

(a)

(b)

# FIG. 5

# FIG. 6

# FIG. 7

(a)

(b)

# FIG. 8

(a)

(b)

# FIG. 9

# FIG. 10

# FIG. 11

(a)

(b)

# FIG. 12

## FIG. 13

# FIG. 14

# FIG. 15

Laser beam

B 2

P 1

S 6

S 5

M 2

S 4

P 2

S 3

S { S 2

B 1

S 1

M

1 c

1 b

1 { 1 a

S 4 1          L

# FIG. 16

# FIG. 17

# FIG. 18

(a)

(b)

FIG. 19

# INTERNATIONAL SEARCH REPORT

| International application No. |
| --- |
| PCT/JP98/05479 |

| A. CLASSIFICATION OF SUBJECT MATTER |
| --- |
| Int.Cl⁶ H01L33/00, H01S3/18 |
| According to International Patent Classification (IPC) or to both national classification and IPC |

**B. FIELDS SEARCHED**

| Minimum documentation searched (classification system followed by classification symbols) |
| --- |
| Int.Cl⁶ H01L33/00, H01S3/18 |

| Documentation searched other than minimum documentation to the extent that such documents are included in the fields searched |
| --- |
| Jitsuyo Shinan Koho          1922-1996   Toroku Jitsuyo Shinan Koho   1994-1999 |
| Kokai Jitsuyo Shinan Koho  1971-1999   Jitsuyo Shinan Toroku Koho  1996-1999 |

| Electronic data base consulted during the international search (name of data base and, where practicable, search terms used) |
| --- |
| JICST File (JOIS) |

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | Appl. Phys. Lett, Vol. 71, No. 16 (1997),<br>pp.2259-2261, 20 October 1997<br>Full text<br>Full text | 1-6, 11-13, 25<br>7-10, 14-24,<br>26 |
| X<br>Y | Jpn. J. Appl. Phys, Vol. 36 (1997), pp.1568-1571, Part 2, No. 12A, 1 December 1997<br>Full text<br>Full text | 1-6, 11-13, 25<br>7-10, 14-24,<br>26 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 17 March, 1999 (17. 03. 99) | 30 March, 1999 (30. 03. 99) |

| Name and mailing address of the ISA/ | Authorized officer |
| --- | --- |
| Japanese Patent Office | |
| Facsimile No. | Telephone No. |

Form PCT/ISA/210 (second sheet) (July 1992)